# EUROPEAN PATENT APPLICATION

(11) **EP 4 395 523 A1**
(43) Date of publication of application: **03.07.2024**
(21) Application number: 22861011.9
(22) Date of filing: 14.07.2022
(51) Int. Cl.: H10N 30/853, H10N 30/076, H10N 30/097, C04B 35/495, C23C 14/08, C23C 14/34

(54) **PIEZOELECTRIC LAMINATE, PRODUCTION METHOD FOR PIEZOELECTRIC LAMINATE, SPUTTERING TARGET MATERIAL, AND PRODUCTION METHOD FOR SPUTTERING TARGET MATERIAL**

(30) Priority: 23.08.2021 JP 2021135874
(71) Applicant: Sumitomo Chemical Company, Limited, Tokyo 103-6020 (JP)
(72) Inventor: KURODA, Toshiaki, Hitachi-shi, Ibaraki 319-1418 (JP); SHIBATA, Kenji, Hitachi-shi, Ibaraki 319-1418 (JP); WATANABE, Kazutoshi, Hitachi-shi, Ibaraki 319-1418 (JP)
(74) Representative: Vossius & Partner Patentanwälte Rechtsanwälte mbB
(86) International application number: PCT/JP2022/027684
(87) International publication number: WO 2023/026720

(57) **Abstract**

Provided is a piezoelectric stack including: a substrate having a main surface with a diameter of 3 inches or more; and a piezoelectric film on the substrate, comprising an alkali niobium oxide containing K, Na, Nb, and O, wherein in the piezoelectric film, a composition of K, Na, and Nb satisfies a relationship of 0.94 ≤ (K + Na)/Nb ≤ 1.03 over an entire inner region of the main surface of the piezoelectric film, excluding its periphery.

## Description

### TECHNICAL FIELD

The present disclosure relates to a piezoelectric stack, a method of manufacturing the piezoelectric stack, a sputtering target material, and a method of manufacturing the sputtering target material.

### DESCRIPTION OF RELATED ART

Piezoelectric materials are widely utilized in functional electronic components such as sensors and actuators. As the piezoelectric material, a piezoelectric material containing potassium (K), sodium (Na), niobium (Nb), and oxygen (O) has been proposed, and a stack (hereinafter referred to as a piezoelectric stack) having a piezoelectric film (KNN film) deposited by a sputtering method using such a piezoelectric material has also been proposed (see, for example, Patent Document 1).

### PRIOR ART DOCUMENT

### PATENT DOCUMENT

Patent Document 1: Japanese Patent Laid Open Publication No. 2017-076730

### SUMMARY

### PROBLEM TO BE SOLVED BY DISCLOSURE

Patent Document 1 discloses that adjusting a composition of a target material enables an adjustment of a composition of the KNN film. However, in the technology described in Patent Document 1, even when the composition ((K + Na)/Nb) of the target material is adjusted so that the composition ((K + Na)/Nb) of the KNN film falls within a predetermined range, spots where the composition of the KNN film does not satisfy the predetermined range sometimes appear on a main surface of the KNN film, in a case where the KNN film is deposited on a substrate with a large diameter of 3 inches or more by the sputtering method using a target material for mass production, specifically, a target material having an area of a surface to be exposed to plasma (sputter surface) of 44.2 cm² or more. This is a new problem first clarified by the inventors through their diligent studies.

It is an object of the present disclosure to provide a piezoelectric stack having a piezoelectric film in which a composition of K, Na, and Nb satisfies a predetermined relationship over an entire inner region of a main surface of the piezoelectric film, excluding its periphery, and also to provide related technologies of the piezoelectric stack.

### MEANS FOR SOLVING PROBLEM

According to an aspect of the present disclosure, there are provided a piezoelectric stack and its manufacturing techniques, including:
a substrate having a main surface with a diameter of 3 inches or more; and
a piezoelectric film on the substrate, comprising an alkali niobium oxide containing K, Na, Nb, and O,
wherein in the piezoelectric film, a composition of K, Na, and Nb satisfies a relationship of 0.94 ≤ (K + Na)/Nb ≤ 1.03 over an entire inner region of the main surface of the piezoelectric film, excluding a periphery of the main surface.

According to another aspect of the present disclosure, there is provided a sputtering target material comprising sintered ceramics including an oxide containing K, Na, Nb, and O,
wherein an area of a surface to be exposed to plasma when depositing a piezoelectric film by a sputtering method is 44.2 cm² or more, and a thickness is 3 mm or more, and
a Vickers hardness of the surface to be exposed to the plasma is 150 or more over an entire inner region of the surface to be exposed to the plasma, excluding a periphery of the surface.

According to still another aspect of the present disclosure, there is provided a method of manufacturing a sputtering target material, the sputtering target material comprising sintered ceramics including an oxide containing K, Na, Nb, and O, and having an area of a surface to be exposed to plasma of 44.2 cm² or more, and having a thickness of 3 mm or more, the method including:
(a) mixing powder comprising a compound of K, powder comprising a compound of Na, and powder comprising a compound of Nb at a predetermined ratio, or mixing powder comprising a compound containing K and Nb and powder comprising a compound containing Na and Nb at a predetermined ratio, to obtain a mixture; and
(b) heating the mixture while applying a predetermined pressure to the mixture, to obtain sintered ceramics having an area of a main surface of 44.2 cm² or more and a thickness of 3 mm or more,
wherein in (b), a pressure is gradually increased at a rate of 1 kgf/cm² or less per minute until the predetermined pressure is reached, and a surface to be a main surface of the sintered ceramics is maintained for 12 hours or more in a state of being at a temperature is 900 to 1200 °C.

### ADVANTAGE OF DISCLOSURE

The present disclosure can provide a piezoelectric stack having a piezoelectric film with a large diameter, in which a composition of K, Na, and Nb satisfies a predetermined relationship over an entire inner region of a main surface of the piezoelectric film, excluding its periphery.

### BRIEF DESCRIPTION OF DRAWINGS

FIG. 1 is a view illustrating an example of a cross-sectional structure of a piezoelectric stack according to one embodiment of the present disclosure.
FIG. 2 is a view illustrating a modified example of the cross-sectional structure of the piezoelectric stack according to one embodiment of the present disclosure.
FIG. 3 is a view illustrating cutting lines of the piezoelectric film when measuring a composition of the piezoelectric film.
FIG. 4 is a view illustrating an example of a schematic configuration of a piezoelectric device module according to one embodiment of the present disclosure.
FIG. 5 is a view illustrating an example of a schematic configuration of a sputtering target material according to one embodiment of the present disclosure.
FIG. 6 is a plan view of a sputter surface showing measurement points of Vickers hardness.
FIG. 7 is a schematic view illustrating a hot press apparatus used when producing a sputtering target material.
FIG. 8(a) is a view illustrating an example of a sequence of a hot press process of one embodiment of the present disclosure, and FIGS. 8(b) and 8(c) are views illustrating modified examples of the sequence of the hot press process of one embodiment of the present disclosure.
FIG. 9 is a view illustrating a modified example of a cross-sectional structure of the piezoelectric device module according to one embodiment of the present disclosure.

### DETAILED DESCRIPTION OF THE DISCLOSURE

### <Findings obtained by inventors>

In a case where a KNN film with a large diameter is deposited on a substrate with a large diameter of 3 inches or more by a sputtering method using a target material for mass production, specifically, a large-sized target material having an area of a surface to be exposed to plasma (hereinafter referred to as a "sputter surface") of 44.2 cm² or more and a thickness of 3 mm or more, spots where a composition of K, Na, and Nb does not satisfy a predetermined relationship, for example, spots where a value of (K + Na)/Nb deviates from a predetermined range, always appear in the resulting KNN film. That is, the KNN film with uniform in-plane distribution of the composition cannot be obtained. This is the new problem recognized by the inventors. It should be noted that K, Na, and Nb in (K + Na)/Nb represent the number of K-atoms, Na-atoms, and Nb-atoms contained per unit volume of the KNN film, respectively.

The inventors have diligently studied the above problems. As a result, when the large-sized target material having the area of the sputter surface of 44.2 cm² or more and the thickness of 3 mm or more is used, (fine) cracks occur on the sputter surface (in the target material) during pre-sputtering or sputter deposition. They have found out that this phenomenon causes spots where the composition of K Na, and Nb does not satisfy a predetermined relationship to appear in the KNN film deposited on the substrate. This is because, when cracks occur on the sputter surface, abnormal electrical discharge occurs at cracked spots during pre-sputtering or sputter deposition. In regions where the abnormal electrical discharge occurs, a temperature elevates locally and becomes higher than in other regions, which promotes volatilization of K and Na locally. As a result, a spot where the composition of K, Na, and Nb does not satisfy the predetermined relationship appears in the KNN film deposited by sputtering.

The inventors have diligently studied the factors causing cracks in the target materials. As a result, they have found out that there is a spot on the sputter surface where bonding between particles is weak, and that a target material larger than a certain size cannot withstand a stress applied to the spot during pre-sputtering or sputter deposition, causing a crack to occur. In addition, the inventors have also found that a hardness of the target material becomes lower in the above-described spot where the bonding between the particles is weak, but no cracks occur in regions where a Vickers hardness is greater than or equal to a predetermined value. To prevent the occurrence of cracks during pre-sputtering or sputter deposition, it has been revealed that it is necessary for the Vickers hardness to be 150 or more when applying a power of 2.7 W/cm², estimated to be the lowest practical power density, to the target material having the area of the sputter surface of 44.2 cm².

The inventors have diligently studied a method of preventing a spot with weak bonding between particles from appearing on the sputter surface of the target material, that is, a method of setting the Vickers hardness of the entire sputter surface to a predetermined value or more. The target material of KNN can be produced, for example, by mixing raw material powders such as powder comprising a compound of K, powder comprising a compound of Na, and powder comprising a compound of Nb, at a predetermined ratio to obtain a mixture, filling the mixture in a predetermined jig, and performing a hot press process on it. The jig is composed of a material such as graphite and is configured to enable formation of sintered ceramics having an area of a main surface of 44.2 cm² or more and a thickness of 3 mm or more. During their research, the inventors have found that "unevenness of filling of raw material powders when filling the raw material powders in the jig" and "unevenness of sintering temperature (firing temperature) in a direction along the main surface of the sintered ceramics (unevenness of sintering temperature)" in producing the target material are factors causing the occurrence of spots with a low Vickers hardness and weak bonding between particles. However, it is difficult to completely eliminate these unevenness even when attempts are made to prevent the unevenness of filling of raw material powders and the unevenness of sintering temperature in producing the target material. In particular, it is very difficult in practice to completely eliminate the unevenness of filling of raw material powders and unevenness of sintering temperature when producing the target material having the area of the sputter surface of 44.2 cm² or more.

The inventors have diligently studied other factors that prevent a spot with weak bonding between particles from appearing on the sputter surface of the target material. As a result, they have found that sintering time (firing time) of raw material powders is important. That is, they have gained findings that during the hot press process, applied pressure is gradually increased at a predetermined rate until it reaches a predetermined pressure, and the sintering time is made much longer than a conventional sintering time, whereby the occurrence of a spot with weak bonding between particles can be suppressed over the entire sputter surface region, even though there is "unevenness of filling of raw material powders" or "unevenness of sintering temperature".

The present disclosure is based on the above findings and problems obtained by the inventors.

### <One embodiment of the present disclosure>

Hereinafter, one aspect of the present disclosure will be described, with reference to drawings.

### (1) Configuration of Piezoelectric Stack

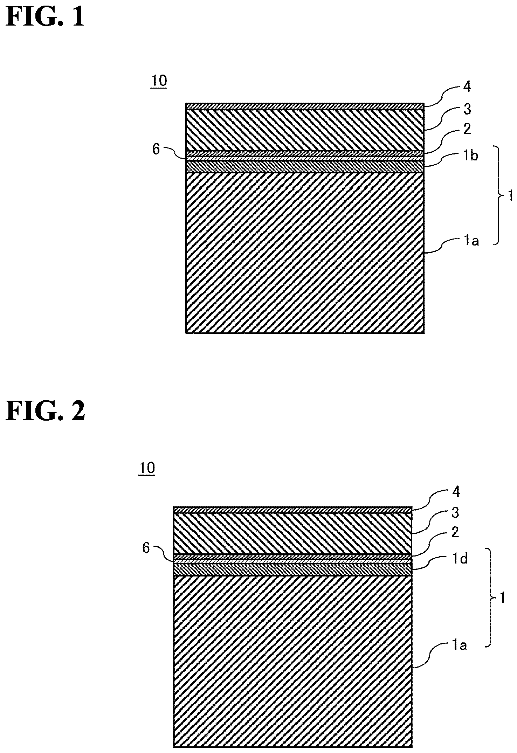

As illustrated in FIG. 1, a stack 10 (hereinafter also referred to as a piezoelectric stack 10) having a piezoelectric film according to this embodiment includes a substrate 1, a bottom electrode film 2 provided on the substrate 1, a piezoelectric film (piezoelectric thin film) 3 provided on the bottom electrode film 2, and a top electrode film 4 provided on the piezoelectric film 3. This embodiment describes an example in which one stacked structure (a structure in which at least the bottom electrode film 2, the piezoelectric film 3, and the top electrode film 4 are stacked) is provided on the single substrate 1.

The substrate 1 has a main surface with a diameter of 3 inches or more. The substrate 1 has a circular outline in planar view. However, the outline of the substrate 1 is not limited to a circular shape. In this case, the substrate 1 preferably has a main surface in which an inscribed circle has a diameter of 3 inches or more. As the substrate 1, a single-crystal silicon (Si) substrate 1a provided with a surface oxide film (SiO₂-film) 1b such as a thermal oxide film or chemical vapor deposition (CVD) oxide film, that is, a Si-substrate provided with a surface oxide film, can be suitably used. Alternatively, as the substrate 1, a Si-substrate 1a with an insulating film 1d comprising an insulating material other than SiO₂ on its surface can also be used, as illustrated in FIG. 2. As the substrate 1, a Si-substrate 1a with an exposed Si-(100) or Si-(111) or the like on its surface, that is, a Si-substrate without the surface oxide film 1b or insulating film 1d, can also be used. Alternatively, as the substrate 1, a silicon on insulator (SOI) substrate, a quartz glass (SiO₂) substrate, a gallium arsenide (GaAs) substrate, a sapphire (Al₂O₃) substrate, a metal substrate comprising a metallic material such as stainless steel (SUS) can also be used. A thickness of the single-crystal Si-substrate 1a can be, for example, 300 to 1000 µm, and a thickness of the surface oxide film 1b can be, for example, 1 to 4000 nm.

The notation of a numerical value range such as "300 to 1000 µm" in this specification means that the lower and upper limits are included in that range. For example, "300 to 1000 µm" means "300 µm or more and 1000 µm or less". The same applies to other numerical value ranges.

The bottom electrode film 2 can be provided using platinum (Pt), for example. The bottom electrode film 2 is a polycrystalline film. Hereinafter, a polycrystalline film deposited using Pt is also referred to as a Pt-film. The Pt-film preferably has its (111) parallel to the main surface of the substrate 1 (including a case where (111) is inclined at an angle within ±5° with respect to the main surface of the substrate 1), that is, the Pt-film is preferably oriented in (111) direction. The "Pt-film is oriented in (111) direction" means that no peaks other than a peak due to (111) is observed in an X-ray diffraction pattern obtained by X-ray diffraction (XRD) as measured on a surface of a KNN film 3. Thus, a main surface of the bottom electrode film 2 (the surface to be a base of the piezoelectric film 3) is preferably composed of Pt-(111). The bottom electrode film 2 can be deposited by a sputtering method, an evaporation method, or the like. The bottom electrode film 2 can also be provided using various metals, in place of Pt, such as gold (Au), ruthenium (Ru), or iridium (Ir); alloys comprising these metals as main components; metal oxides such as strontium ruthenium oxide (SrRuO₃, abbreviated as SRO) or lanthanum nickel oxide (LaNiO₃, abbreviated as LNO); or the like. The bottom electrode film 2 can be a monolayer film provided using the above-described various metals, metal oxides, or the like. The bottom electrode film 2 can also be a stack of a Pt-film and a film mainly comprising SRO provided on the Pt-film, a stack of a Pt-film and a film mainly comprising LNO provided on the Pt-film, or the like. To enhance adhesion between the substrate 1 and the bottom electrode film 2, an adhesion layer 6 may also be provided between them. The adhesion layer 6 is mainly comprised, for example, titanium (Ti), tantalum (Ta), titanium oxide (TiO₂), nickel (Ni), ruthenium oxide (RuO₂), iridium oxide (IrO₂), zinc oxide (ZnO), or the like. The adhesion layer 6 can be deposited by a method such as the sputtering method or the evaporation method. A thickness of the bottom electrode film 2 (in a case where the bottom electrode film 2 is a stack, a total thickness of respective layers) can be, for example, 100 to 400 nm, and a thickness of the adhesion layer 6 can be, for example, 1 to 200 nm.

The piezoelectric film 3 is a film comprising an alkali niobium oxide containing, for example, potassium (K), sodium (Na), niobium (Nb), and oxygen (O). That is, the piezoelectric film 3 is a film mainly composed of an alkali niobium oxide containing K, Na, Nb, and O. The piezoelectric film 3 can be provided using an alkali niobium oxide represented by a composition formula (K₁₋ₓNaₓ)NbO₃, that is, using a potassium sodium niobium oxide (KNN). A coefficient x [= Na/(K + Na)] in the above composition formula can be within a range of 0 < x < 1, preferably 0.4 ≤ x ≤ 0.8. The piezoelectric film 3 is a polycrystalline film of KNN (hereinafter also referred to as a KNN film 3). A crystal structure of KNN is a perovskite structure. That is, the KNN film 3 has the perovskite structure. Half or more of crystals in a crystal group constituting the KNN film 3 preferably have a columnar structure. In this specification, a crystal system of KNN is considered to be a tetragonal crystal system. The KNN film 3 can be deposited by a method such as the sputtering method.

Preferably, the crystals constituting the KNN film 3 are preferentially oriented in (001) direction with respect to the main surface of the substrate 1 (or the Si-substrate 1a in a case where the substrate 1 is, for example, the Si-substrate 1a with the surface oxide film 1b or insulating film 1d). That is, a main surface of the KNN film 3 (a surface to be a base of the top electrode film 4) is preferably mainly composed of KNN-(001). For example, by depositing the KNN film 3 directly on the Pt-film (bottom electrode film 2) whose main surface is mainly composed of Pt-(111), the KNN film 3 whose main surface is mainly composed of KNN-(001) can be obtained.

In this specification, the "crystals constituting the KNN film 3 are oriented in (001) direction" means that (001) of crystals constituting the KNN film 3 are parallel or substantially parallel to the main surface of the substrate 1. The "crystals constituting the KNN film 3 are preferentially oriented in (001) direction" means that there are many crystals in which (001) is parallel or substantially parallel to the main surface of the substrate 1. For example, 80 % or more of the crystals in the crystal group constituting the KNN film 3 are preferably oriented in (001) direction with respect to the main surface of the substrate 1. That is, an orientation ratio of the crystals constituting the KNN film 3 in (001) direction is, for example, preferably 80 % or more, and more preferably 90 % or more. The term "orientation ratio" in this specification refers to a value calculated using the following (Equation 1) based on peak intensities of an X-ray diffraction pattern (2θ/θ) obtained by performing XRD measurement on the KNN film 3. Orientation ratio (%) = {(001) peak intensity/((001) peak intensity + (001) peak intensity)} × 100

The term "(001) peak intensity" in the above (Equation 1) refers to the intensity of a diffraction peak due to crystals oriented in (001) direction (i.e., crystals whose (001) is parallel to the main surface of the substrate 1) among the crystals constituting the KNN film 3, in the X-ray diffraction pattern obtained by performing XRD measurement on the KNN film 3. The (001) peak intensity is the intensity of a peak appearing within a range that 20 is 20° to 23°. When multiple peaks appear within the range that 20 is 20° to 23°, it refers to the intensity of the highest peak. The term "(110) peak intensity" in the above (Equation 1) refers to the intensity of a diffraction peak due to crystals oriented in (110) direction (i.e., crystals whose (110) is parallel to the main surface of the substrate 1) among the crystals constituting the KNN film 3, in the X-ray diffraction pattern obtained by performing the XRD measurement on the KNN film 3. The (110) peak intensity is the intensity of the peak appearing within a range that 20 is 30° to 33°. When multiple peaks appear within the range that 20 is 30° to 33°, it refers to the intensity of the highest peak.

The KNN film 3 has a main surface (top surface) with a diameter of 3 inches or more, that is, a main surface with a large diameter. A composition of K, Na, and Nb in the KNN film 3 satisfies a relationship of 0.94 ≤ (K + Na)/Nb ≤ 1.03, preferably 0.96 ≤ (K + Na)/Nb ≤ 1.00, over an entire inner region of the main surface of the KNN film 3, excluding its periphery. K, Na, and Nb in the formula of (K + Na)/Nb here represent the number of K-atoms, Na-atoms, and Nb-atoms contained per unit volume of the KNN film 3, respectively. Thus, a distribution of the composition of K, Na, and Nb in the KNN film 3 is uniform (in-plane uniform) over the entire inner region of the main surface of the KNN film 3, excluding its periphery.

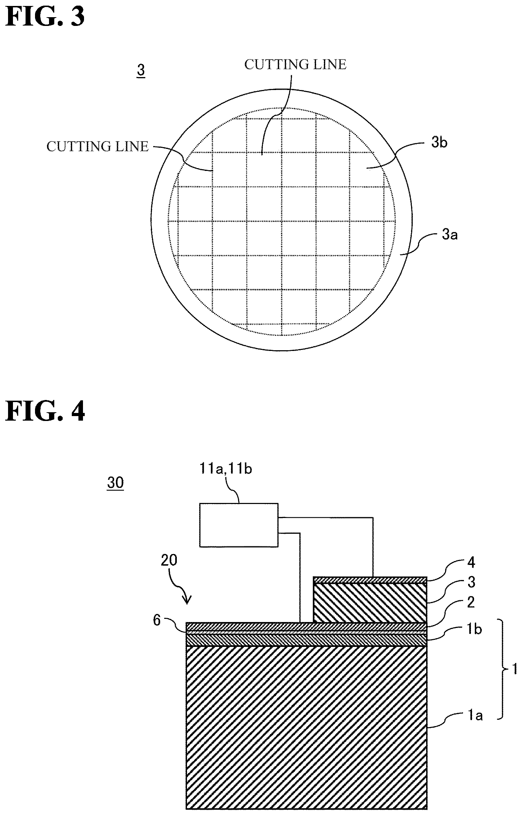

Here, the "the composition of K, Na, and Nb in the KNN film 3 satisfies the relationship of 0.94 ≤ (K + Na)/Nb ≤ 1.03 over the entire inner region of the main surface of the KNN film 3 excluding its periphery" means that the relationship of 0.94 ≤ (K + Na)/Nb ≤ 1.03 is satisfied by all samples, when measuring the composition of samples with a plane area of 25 mm² or more (32 samples in a case where the KNN film 3 has a main surface with a diameter of 3 inches) among a plurality of samples obtained by cutting the KNN film 3 at 1 cm intervals in a grid pattern over a region 3b located inside an outer peripheral region 3a having a width of 5 mm from an edge (region 3b excluding the outer peripheral region 3a having a width of 5 mm from the edge) of the surface of the KNN film 3, as illustrated in FIG. 3. In FIG. 3, cutting lines of the KNN film 3 are indicated by dotted lines. The "plane area" as used herein means an area of the main surface of the KNN film 3 when viewed from the vertical upper side of the main surface of the KNN film 3. The "entire inner region of the main surface of the KNN film 3, excluding its periphery" in this specification is also described as "the entire main surface region of the KNN film 3".

The composition of K and Na in the KNN film 3 can be measured by atomic absorption spectrometry (AAS) or the like, and the composition of Nb can be measured by inductively coupled plasma atomic emission spectroscopy (ICP-AES) or the like. Specifically, first, each sample obtained by cutting the KNN film 3 is decomposed by heating with sulfuric acid, nitric acid, hydrofluoric acid, and hydrochloric acid, and then dissolved by heating with dilute hydrogen peroxide water and dilute hydrofluoric acid to make up a constant volume. The resulting solution is subjected to AAS and ICP-AES to determine contents of K, Na, and Nb in the sample, which are then converted to an atomic number ratio thereof. Thus, the composition of K, Na, and Nb in the KNN film 3 can be determined. AAS can be performed using, for example, Z-2300, manufactured by Hitachi High-Technologies Corporation, and ICP-AES can be performed using, for example, PS3520VDDII, manufactured by Hitachi High-Tech Science Corporation. It is also conceivable that the composition of K, Na, and Nb in the KNN film 3 is measured by energy-dispersive X-ray spectroscopy (EDS), X-ray fluorescence (XRF), or ICP-AES alone. However, in this case, it is difficult to accurately measure the above composition in the KNN film 3 due to low analytical sensitivity of K and Na, so that the composition of the KNN film 3 cannot be evaluated accurately. As described above, the composition of the KNN film 3 can be evaluated accurately by measuring the composition of K, Na, and Nb of the KNN film 3 using both AAS and ICP-AES.

The composition of K, Na, and Nb in the KNN film 3 satisfies 0.94 ≤ (K + Na)/Nb ≤ 1.03, thereby allowing a dielectric breakdown voltage of the KNN film 3 to be, for example, 300 kV/cm or more, preferably 500 kV/cm or more. The "dielectric breakdown voltage" in this specification is an electric field value at which a current density becomes 100 µA/cm² or more when applying a predetermined electric field to the KNN film 3 in its thickness direction.

The composition of K, Na, and Nb satisfies the above relationship over the entire main surface region of the KNN film 3, thereby allowing the dielectric breakdown voltage of the KNN film 3 to be made uniform (in-plane uniform) over the entire main surface region of the KNN film 3. That is, the dielectric breakdown voltage of the KNN film 3 can be, for example, 300 kV/cm or more, preferably 500 kV/cm or more, over the entire main surface region. This can avoid variations in dielectric breakdown voltage among a plurality of piezoelectric elements 20 (piezoelectric device modules 30) described later, obtained from one piezoelectric stack 10. As a result, a yield and a reliability of piezoelectric element 20 (piezoelectric device module 30) can be improved.

A thickness of the KNN film 3 is, for example, 0.5 µm or more, preferably 0.5 to 5 µm over the entire main surface region of the KNN film 3. This ensures that variations in dielectric breakdown voltage can be avoided among the plurality of piezoelectric elements 20 (piezoelectric device modules 30) described later, obtained from one piezoelectric stack 10.

The alkali niobium oxide constituting the KNN film 3 may further contain at least one element (dopant) selected from the group consisting of lithium (Li), magnesium (Mg), calcium (Ca), strontium (Sr), barium (Ba), bismuth (Bi), antimony (Sb), vanadium (V), indium (In), Ta, molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). A concentration of such an element in the alkali niobium oxide can be, for example, 5 at% or less (when more than one of the above elements are contained, a total concentration thereof can be 5 at% or less).

The top electrode film 4 is mainly composed of, for example, various metals such as Pt, Au, Al, or Cu, or an alloy comprising these various metals. The top electrode film 4 can be deposited by a method such as the sputtering method, the evaporation method, a plating method, a metal paste method, or the like. The top electrode film 4 does not significantly affect the crystal structure of the KNN film 3, unlike the bottom electrode film 2. Therefore, the material, crystal structure, and deposition method of the top electrode film 4 are not particularly limited. To enhance adhesion between the KNN film 3 and the top electrode film 4, an adhesion layer may be provided between them. This adhesion layer is mainly composed of, for example, Ti, Ta, TiO₂, Ni, RuO₂, IrO₂, or the like. A thickness of the top electrode film 4 can be, for example, 100 to 5000 nm, and in a case where the adhesion layer is provided, a thickness of the adhesion layer can be, for example, 1 to 200 nm.

### (2) Configuration of Piezoelectric Device Module

FIG. 4 illustrates a schematic configuration view of a device module 30 including the KNN film 3 (hereinafter also referred to as a piezoelectric device module 30). By shaping the piezoelectric stack 10 described above into a predetermined shape, an element (device) 20 (element 20 including the KNN film 3, hereinafter also referred to as a piezoelectric element 20) as illustrated in FIG. 4 is obtained. The piezoelectric device module 30 includes at least the piezoelectric element 20, and a voltage applicator 11a or a voltage detector 11b connected to the piezoelectric element 20. The voltage applicator 11a is a means that applies a voltage between the bottom electrode film 2 and the top electrode film 4, and the voltage detector 11b is a means that detects a voltage generated between the bottom electrode film 2 and the top electrode film 4. Various known means can be used as the voltage applicator 11a and the voltage detector 11b.

The piezoelectric device module 30 can function as an actuator by connecting the voltage applicator 11a between the bottom electrode film 2 and the top electrode film 4 of the piezoelectric element 20. The KNN film 3 can be deformed by applying a voltage between the bottom electrode film 2 and the top electrode film 4 using the voltage applicator 11a. This deformation action allows various components connected to the piezoelectric device module 30 to be operated. In this case, applications of the piezoelectric device module 30 include, for example, a head for an inkjet printer, a MEMS mirror for a scanner, and a transducer for an ultrasonic generator.

The piezoelectric device module 30 can function as a sensor by connecting the voltage detector 11b between the bottom electrode film 2 and the top electrode film 4 of the piezoelectric element 20. When the KNN film 3 is deformed due to changes in some physical quantity, the deformation generates a voltage between the bottom electrode film 2 and the top electrode film 4. This voltage can be detected by the voltage detector 11b, thereby measuring a magnitude of the physical quantity applied to the KNN film 3. In this case, applications of the piezoelectric device module 30 include, for example, an angular velocity sensor, an ultrasonic sensor, a pressure sensor, and an acceleration sensor.

The piezoelectric device module 30 (piezoelectric element 20) is produced from the piezoelectric stack 10 including the KNN film 3 in which the composition of K, Na, and Nb satisfies the relationship of 0.94 ≤ (K + Na)/Nb ≤ 1.03 over the entire main surface region. This can avoid variations in dielectric breakdown voltage among a plurality of piezoelectric device modules 30 (piezoelectric elements 20) obtained from one piezoelectric stack 10. That is, the plurality of piezoelectric device modules 30 with uniform dielectric breakdown voltage can be obtained from one piezoelectric stack 10. Thus, the dielectric breakdown voltage is made uniform among the plurality of piezoelectric device modules 30, which enables improvement in the yield and the reliability of the piezoelectric device modules 30.

### (3) Methods of Manufacturing Piezoelectric stack, Piezoelectric Element, and Piezoelectric Device Module

Methods of manufacturing the piezoelectric stack 10, piezoelectric element 20, and piezoelectric device module 30 described above will be described.

### (Deposition of Adhesion Layer and Bottom Electrode Film)

First, the substrate 1 with a large diameter having a main surface of 3 inches or more is prepared, and the adhesion layer 6 (e.g., a Ti-layer) and the bottom electrode film 2 (e.g., a Pt-film) are deposited in this order on any one of the main surfaces of the substrate 1 by, for example, the sputtering method. It is also acceptable to prepare the substrate 1 on which the adhesion layer 6 and/or the bottom electrode film 2 are deposited in advance on any one of the main surfaces of the substrate 1.

Conditions for providing the adhesion layer 6 are exemplified as follows.
Temperature (substrate temperature): 100 to 500 °C, preferably 200 to 400 °C
RF-power density: 12.3 to 18.5 W/cm², preferably 13.5 to 17.3 W/cm²
Atmosphere: Argon (Ar) gas atmosphere
Atmospheric pressure: 0.1 to 0.5 Pa, preferably 0.2 to 0.4 Pa
Time: 30 seconds to 3 minutes, preferably 45 seconds to 2 minutes

Conditions for depositing the bottom electrode film 2 are exemplified as follows.
Temperature (substrate temperature): 100 to 500 °C, preferably 200 to 400 °C
RF-power density: 12.3 to 18.5 W/cm², preferably 13.5 to 17.3 W/cm²
Atmosphere: Ar-gas atmosphere
Atmospheric pressure: 0.1 to 0.5 Pa, preferably 0.2 to 0.4 Pa
Time: 3 to 10 minutes, preferably 4 to 8 minutes, more preferably 5 to 6 minutes

### (Deposition of KNN Film)

After the depositions of the adhesion layer 6 and the bottom electrode film 2 are completed, the KNN film 3 is subsequently deposited on the bottom electrode film 2 by, for example, the sputtering method such as an RF magnetron sputtering method. In this event, a large-sized target material 100 comprising KNN-sintered ceramics and having a minimum value of the Vickers hardness of 150 within a sputter surface 101, that is, the later described target material 100 with a high Vickers hardness of the sputter surface 101 over the entire in-plane region, is used. The composition of the KNN film 3 can be adjusted by controlling a composition of the target material 100, for example. That is, the target material 100 is used which has its composition controlled to satisfy a relationship of R1 > R2, where R1 is an average value of (K + Na)/Nb within the sputter surface 101, and R2 is an average value of (K + Na)/Nb within the main surface of the KNN film 3 to be deposited. Details of the target material 100 will be described later.

Conditions for depositing the KNN film 3 are exemplified as follows. Deposition time can be set as appropriate according to the thickness of the KNN film 3.
RF-power density: 2.7 to 4.1 W/cm², preferably 2.8 to 3.8 W/cm²
Atmosphere: atmosphere containing at least oxygen (O₂) gas, preferably a mixed gas atmosphere of Ar-gas and O₂-gas
Atmospheric pressure: 0.2 to 0.5 Pa, preferably 0.2 to 0.4 Pa
Ratio of partial pressure of Ar-gas to O₂-gas (Ar-gas partial pressure/O₂-gas partial pressure): 30/1 to 20/1
Temperature (substrate temperature): 500 to 700 °C, preferably 550 to 650 °C
Deposition rate: 0.5 to 4 µm/hr

As described later, the Vickers hardness of the sputter surface 101 of the target material 100 is high over the entire in-plane region, thereby enabling suppression of cracks on the sputter surface 101 during pre-sputtering or sputter deposition. In particular, even when the sputter deposition is performed at a high RF-power density of 2.7 to 4.1 W/cm² (2000 to 3000 W/12-inch diameter circle), cracks on the sputtered film 101 can be suppressed. Thus, the occurrence of abnormal electrical discharge can be avoided over the entire sputter surface region during pre-sputtering or sputter deposition. As a result, local volatilization of K and Na from the sputter surface 101 can be avoided. Since the target material 100 described later is used during the sputter deposition of the KNN film 3, the KNN film 3 can be obtained in which the composition of K, Na, and Nb satisfies the relationship of 0.94 ≤ (K + Na)/Nb ≤ 1.03 over the entire main surface region, even when the KNN film 3 with a large diameter is deposited on the substrate 1 with a large diameter (on the bottom electrode film 2 with a large diameter deposited on the substrate 1 with a large diameter). Although some alkali from the target material 100 (sputter surface 101) is scattered during pre-sputtering or sputter deposition, the use of the target material 100 satisfying the above relationship of R1 > R2 can obtain the KNN film 3 in which the composition of K, Na, and Nb satisfies the relationship of 0.94 ≤ (K + Na)/Nb ≤ 1.03 over the entire main surface region.

### (Deposition of Top Electrode Film)

After the deposition of the KNN film 3 is completed, the top electrode film 4 is deposited on the KNN film 3 by the sputtering method, for example. Conditions for depositing the top electrode film 4 can be set similar to those for depositing the bottom electrode film 2 described above. Thus, the piezoelectric stack 10 such as that illustrated in FIG. 1 is obtained.

### (Production of Piezoelectric Element and Piezoelectric Device Module)

Then, the resulting piezoelectric stack 10 is shaped into a predetermined shape (is subjected to fine processing into a predetermined pattern) by etching or the like. Thus, the piezoelectric element 20 as illustrated in FIG. 4 is obtained, and the piezoelectric device module 30 is obtained by connecting the voltage applicator 11a or voltage detector 11b to the piezoelectric element 20. Examples of etching methods include a dry etching method such as reactive ion etching or a wet etching method using a predetermined etchant.

When the piezoelectric stack 10 is shaped by dry etching, a photoresist pattern as an etching mask for dry etching is provided on the piezoelectric stack 10 (e.g., top electrode film 4) by a photolithography process or the like. A precious metal film (metal mask) such as a Cr-film, Ni-film, Pt-film, or Ti-film may be provided as the etching mask by the sputtering method. Then, dry etching is performed on the piezoelectric stack 10 (top electrode film 4, KNN film 3, and the like) using a gas containing a halogen element as an etching gas. Examples of the halogen element include chlorine (Cl), fluorine (F), or the like. BCh-gas, SiCl₄-gas, Cl₂-gas, CF₄-gas, C₄F₈-gas, or the like can be used as the gas containing the halogen element.

When the piezoelectric stack 10 is shaped by wet etching, a silicon oxide (SiOₓ) film or the like as an etching mask for wet etching is provided on the piezoelectric stack 10 (e.g., top electrode film 4). Then, wet etching is performed on the piezoelectric stack 10 (top electrode film 4, KNN film 3, and the like) by immersing the piezoelectric stack 10 in an etchant containing an alkaline aqueous solution of a chelating agent but not containing hydrofluoric acid, for example. As the etchant containing the alkaline aqueous solution of the chelating agent but not containing hydrofluoric acid, an etchant obtained by mixing ethylenediaminetetraacetic acid as the chelating agent, aqueous ammonia, and hydrogen peroxide solution can be used.

### (4) Configuration of Target Material

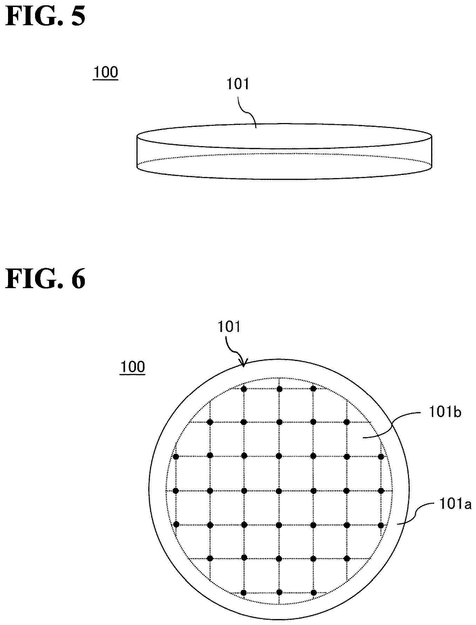

Hereinafter, a configuration of a sputtering target material 100 that is used during the sputter deposition of the KNN film 3 will be described in detail with reference to FIG. 5. The target material 100 is affixed to a backing plate via an adhesive such as In, and then mounted in a sputtering apparatus such that the sputter surface 101 is irradiated with plasma, for example. As described above, the "sputter surface" is a surface to be exposed to plasma during sputter deposition (a surface where ions impinge during sputter deposition), among the surfaces of the target material 100.

FIG. 5 is a schematic configuration view illustrating an example of the sputtering target material 100 according to this embodiment. In FIG. 5, the target material 100 is illustrated with the sputter surface 101 facing upward.

The target material 100 is composed of sintered ceramics including an oxide(s) containing K, Na, Nb, and O, that is, KNN-sintered ceramics. Crystal grains mainly constituting the KNN-sintered ceramics have a perovskite structure. In addition to the oxide containing K, Na, Nb, and O, the KNN-sintered ceramics may also sometimes contain a carbonate or an oxalate originating from raw materials described later.

A composition of K, Na, and Nb ((K + Na)/Nb) in the target material 100 satisfies a relationship of 0.95 ≤ (K + Na)/Nb ≤ 1.2, preferably 1 ≤ (K + Na)/Nb ≤ 1.1. K, Na, and Nb in the formula of (K + Na)/Nb here represent the numbers of K-atoms, Na-atoms, and Nb-atoms contained per unit volume of the KNN-sintered ceramics, respectively. Thus, the composition of the target material 100 needs to be slightly richer in K and Na than the composition of the KNN film 3 to be deposited. For example, the composition of the target material 100 needs to be adjusted such that the relationship of R1 > R2 is satisfied, where R1 is an average value of (K + Na)/Nb within the sputter surface 101, and R2 is an average value of (K + Na)/Nb within the main surface of the KNN film 3 to be deposited. This is because, during sputter deposition with the substrate 1 heated to a high temperature, the value of (K + Na)/Nb in the KNN film 3 slightly shifts toward a smaller side from the value of (K + Na)/Nb in the target material 100 due to alkali scattering during the sputtering process. The amount of this shift depends on sputter deposition conditions (substrate temperature, RF-power density, deposition rate, apparatus configuration, or the like). Making the composition of the target material 100 slightly richer in K and Na than that of the KNN film 3 enables production of the KNN film 3 in which the composition of K, Na, and Nb satisfies the above relationship over the entire main surface region. The composition (K + Na)/Nb) of the target material 100 can be measured (calculated) by known methods.

The target material 100 may further contain, as a dopant, at least one element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga. A concentration of such an element in the target material 100 can be, for example, 5 at% or less (when more than one of the above elements are contained, a total concentration thereof can be 5 at% or less).

The target material 100 has a circular outline. That is, the target material 100 has the sputter surface 101 having a circular shape in planar view. The outline of the target material 100 (planar shape of the sputter surface 101) may be various shapes other than the circular shape, such as an oval shape, a rectangular shape, or a polygonal shape. An area of the sputter surface 101 is 44.2 cm² or more. For example, the sputter surface 101 has an area larger than the substrate 1 with a diameter of 3 inches. The "area of the sputter surface 101" as used herein means an area of the sputter surface 101 when viewed from the vertical upper side of the sputter surface 101. The target material 100 has a thickness of 3 mm or more. The upper limit of the thickness of the target material 100 is not particularly limited, but can be 20 mm or less, for example.

A Vickers hardness of the sputter surface 101 (hereinafter referred to simply as "Vickers hardness") is 150 or more, preferably 200 or more, over the entire inner region of the sputter surface 101, excluding its periphery. That is, the minimum value of the Vickers hardness in the sputter surface 101 is 150 or more, and preferably 200 or more.

Here, the "the Vickers hardness of the sputter surface 101 is 150 or more over the entire inner region of the sputter surface 101, excluding its periphery" means that, as illustrated in FIG. 6, when the hardness is measured at measurement points set at 1 cm intervals in a grid pattern over a region 101b of the sputter surface 101, excluding a region (periphery) 101a having a width of 5 mm from an edge of the sputter surface 101 (i.e., a region located inside a region having a width of 5mm from the edge), the Vickers hardness is 150 or more at all measurement points (37 points in a case where the sputter surface 101 has a circular outline with its area of 44.2 cm²). FIG. 6 illustrates the measurement points of the Vickers hardness, indicated by marks • (black circles). The "entire inner region of the sputter surface 101, excluding its periphery" in this specification is also described as "the entire sputter surface region".

The Vickers hardness was measured in accordance with JISR1610 by making an indentation on a test surface (the sputter surface 101) under the following test conditions, using a micro-Vickers hardness tester HM-114, manufactured by Mitutoyo Corporation. Specifically, the Vickers hardness was calculated from a testing force obtained when an indentation (recess) was made on the test surface using a Vickers indenter (a square pyramid indenter having a square base with an angle of 136 degrees between two surfaces facing each other), and from an indentation surface area determined from a diagonal length of the indentation.

### (Test Conditions)

Atmosphere: Air
Temperature, Humidity: 25 °C, 52 %
Testing force: 1.0 kgf
Load application rate: 10 µm/s
Retention time: 15 sec
Number of measurement points: 37 points

As described above, since the Vickers hardness is 150 or more over the entire sputter surface region, the occurrence of cracks on the sputter surface 101 can be suppressed during pre-sputtering or sputter deposition. Thus, the occurrence of abnormal electrical discharge can be avoided over the entire sputter surface region during sputter deposition. Therefore, regions with locally increased temperature can be avoided from appearing on the sputter surface 101 during sputter deposition, and local volatilization of K and Na from the sputter surface 101 can also be avoided. As a result, the KNN film 3 with a large diameter, in which the composition of K, Na, and Nb satisfies the relationship of 0.94 ≤ (K + Na)/Nb ≤ 1.03 over the entire main surface region, can be obtained.

The inventors have already confirmed that when the Vickers hardness is 150 or more over the entire sputter surface region, even the target material 100 with a large diameter having the area of the sputter surface 101 of 44.2 cm² or more and the thickness of 3 mm or more does not occur any spots with weak bonding between particles over the entire sputter surface region. In addition, it has been confirmed that such the target material 100 can avoid the occurrence of cracks during pre-sputtering or sputter deposition and the occurrence of abnormal electrical discharge during sputter deposition, and can also sufficiently suppress the occurrence of deviations in the composition of K, Na, and Nb in the KNN film 3 deposited by sputtering (hereinafter also referred to as "deviations in the composition of the KNN film 3"). When the Vickers hardness is 200 or more over the entire sputter surface region, the occurrence of the above cracks and the occurrence of abnormal electrical discharge can be surely avoided, and the occurrence of deviations in the composition of the KNN film 3 can be surely suppressed.

In addition, since the occurrence of cracks is suppressed, in any of a plurality of the KNN films 3 repeatedly deposited using one target material 100, the composition of K, Na, and Nb satisfies the relationship of 0. 94 ≤ (K + Na)/Nb ≤ 1.03 over the entire main surface region of the KNN film 3. That is, during the production of the piezoelectric stack 10, the occurrence of deviations in the composition of the KNN film 3 can be suppressed on a run-to-run basis. As a result, the composition of the KNN film 3 can be made uniform among the plurality of piezoelectric stacks 10, which enables further improvement in the yield and the reliability of the piezoelectric element 20 and the piezoelectric device module 30.

When the Vickers hardness is not 150 or more over the entire sputter surface region, that is, when a region (spot) with the Vickers hardness of less than 150 appears on the sputter surface 101, cracks occur starting from the region with the Vickers hardness of less than 150 during pre-sputtering or sputter deposition, causing abnormal electrical discharge to occur at the cracked spot during sputter deposition. As a result, regions that do not satisfy the above relationship may sometimes appear on the main surface of the KNN film 3 deposited by sputtering.

The upper limit of the Vickers hardness is not particularly limited. However, to further increase the Vickers hardness, sintering over a further prolonged period (heating over a prolonged period) is required in the hot press process described later. Thus, from the viewpoint of ensuring productivity and suppressing cost increase, the Vickers hardness can be, for example, 650 or less. That is, the Vickers hardness can be, for example, within a range of 150 or more and 650 or less, preferably within a range of 200 or more and 650 or less.

A relative density of the target material 100 is 60 % or more, preferably 70 % or more, and more preferably 80 % or more over the entire sputter surface region. The "relative density (%)" as used herein refers to a value calculated by (measured density/theoretical density of KNN) × 100. It should be noted that the theoretical density of KNN is 4.51 g/cm³. Thus, the occurrence of abnormal electrical discharge can be surely avoided over the entire sputter surface region during the sputter deposition of the KNN film 3.

The target material 100 preferably has high resistance. For example, a volume resistivity of the target material 100 is preferably 1000 kQcm or more, and more preferably 1000 kQcm or more over the entire sputter surface region. Thus, the KNN film 3 with favorable insulating properties can be obtained. The upper limit of the volume resistivity is not particularly limited, but can be 100 MΩcm or less, for example.

### (5) Method of Manufacturing Target Material

Hereinafter, a method of manufacturing the target material 100 in which the Vickers hardness is 150 or more over the entire sputter surface region will be described in detail.

In a production sequence of the target material 100 according to this embodiment, the following processes are performed:
a process (mixing process) of mixing powder comprising a compound of K, powder comprising a compound of Na, and powder comprising a compound of Nb, at a predetermined ratio, to obtain a mixture; and
a process (hot press process) of heating the mixture while applying a predetermined pressure to the mixture, to obtain sintered ceramics having an area of a main surface of 44.2 cm² or more and a thickness of 3 mm or more. In the hot press process, a pressure is gradually increased at a rate of 1 kgf/cm² or less per minute until the predetermined pressure is reached, and a surface to be a main surface of the obtained sintered ceramics is maintained for 12 hours or more in a state of being at a temperature of 900 to 1200 °C.

It is also acceptable to further perform after performing the mixing process and before performing the hot press process:
a process (pre-firing process) of pre-firing the mixture by heating at a predetermined temperature; and
a process (pulverizing process) of pulverizing the mixture after the pre-firing. In this case, the hot press process is applied on the mixture pulverized after the pre-firing.

It is also acceptable to further perform after the hot press process: a process (heat treatment) of heating the sintered ceramics at a predetermined temperature.

### (Mixing process)

The powder comprising the compound of K, the powder comprising the compound of Na, and the powder comprising the compound of Nb are mixed, at the predetermined ratio, to obtain a mixture.

Specifically, first, the powder comprising the compound of K, the powder comprising the compound of Na, and the powder comprising the compound of Nb are prepared. The "powder comprising a compound of K" as used herein means powder containing the compound of K as a main component, and it may include a case in which the powder consists of the compound of K, as well as a case in which the powder contains powders of other compounds in addition to the powder, which is the main component, of the compound of K. Similarly, the "powder comprising a compound of Na" as used herein means powder containing the compound of Na as a main component, and it may include a case in which the powder consists of the compound of Na, as well as a case in which the powder contains powders of other compounds in addition to the powder, which is the main component, of the compound of Na. The "powder comprising a compound of Nb" as used herein means powder containing the compound of Nb as a main component, and it may include a case in which the powder consists of the compound of Nb, as well as a case in which the powder contains powders of other compounds in addition to the powder, which is the main component, of the compound of Nb.

The compound of K is at least one selected from the group consisting of oxides of K, composite oxides of K, and compounds (e.g., carbonates, oxalates) of K that are transformed into oxides when heated. For example, potassium carbonate (K₂CO₃) powder can be used as the powder comprising the compound of K.

The compound of Na is at least one selected from the group consisting of oxides of Na, composite oxides of Na, and compounds (e.g., carbonates, oxalates) of Na that are transformed into oxides when heated. For example, sodium carbonate (Na₂CO₃) powder can be used as the powder comprising the compound of Na.

The compound of Nb is at least one selected from the group consisting of oxides of Nb, composite oxides of Nb, and compounds of Nb that are transformed into oxides when heated. For example, niobium oxide (NbaOs) powder can be used as the powder comprising the compound of Nb.

When the target material 100 containing a predetermined dopant is to be produced, at least one of the following powders is prepared: powder comprising a compound of at least one element selected from the group of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga; and powder of at least one element alone selected from the group of the elements described above. The powder of the compound of each of the above elements refers to at least one selected from the group consisting of powders of oxides of each of the above elements, powders of composite oxides of each of the above elements, and compounds (e.g., carbonates, oxalates) of each of the above elements that are transformed into oxides when heated.

Then, a mixing ratio of each of the above powders is adjusted such that the composition of the target material 100 becomes the predetermined composition, and each powder (raw material powder) is weighed. Although weighing may be performed in air, it is preferably performed in an inert gas atmosphere such as Ar-gas or nitrogen (N₂) gas from the viewpoint of avoiding deviations in the composition ratio of the target material 100. In addition, weighing is preferably performed after each powder is sufficiently dried (dehydrated) from the viewpoint of ensuring that the deviations in the composition ratio of the target material 100 are avoided.

Subsequently, the respective powders are mixed (wet mixed) using a mixer such as a ball mill or a bead mill. Conditions for mixing are exemplified as follows.
Solvent: organic solvent such as ethanol, or water
Mixing time: 5 to 30 hours, preferably 10 to 26 hours
Mixing atmosphere: air

By mixing the powders under the conditions described above, agglomeration of the powders can be avoided, and the composition of the target material 100 can be easily made uniform over the entire sputter surface region and over an entire region in a thickness direction.

### (Pre-Firing Process and Pulverizing Process)

After the mixing process is completed, the mixture obtained by the mixing process is pre-fired by being heated at a predetermined temperature (pre-firing process).

### Conditions for pre-firing are exemplified as follows.

Heating temperature: 650 to 1100 °C, preferably 700 to 900 °C, more preferably 700 °C or higher and less than 800 °C
Heating time: 1 to 50 hours, preferably 5 to 40 hours, more preferably 10 to 35 hours

After the pre-firing process is completed, the mixture after pre-firing is mixed while being pulverized using a ball mill or the like (pulverizing process).

Conditions for pulverizing are exemplified as follows.
Pulverizing (mixing) time: 3 to 10 hours, preferably 5 to 9 hours
Other conditions can be similar to those in the mixing process described above.

By pre-firing and pulverizing the mixture under the conditions described above, the composition of the target material 100 can be made more uniform over the entire sputter surface region.

### (Filling Process)

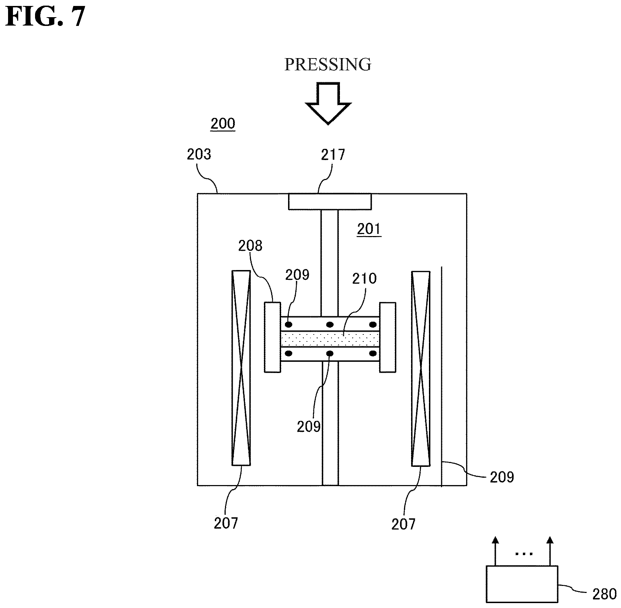

After the pre-firing process and the pulverizing processes are completed, the mixture (raw material powder) obtained by pulverizing and mixing after pre-firing is filled (accommodated) in a specified jig 208 (see FIG. 7). In this event, the raw material powder is filled in the jig 208 so as to minimize any unevenness of filling of the raw material powders as much as possible. The jig 208 is composed of a material such as graphite and is configured to enable formation sintered ceramics (molding) having an area of a main surface of 44.2 cm² or more and a thickness of 3 mm or more. The jig 208 is configured such that it can be put into a processing chamber 201 included in a hot press apparatus 200 described later and such that it is not damaged due to a pressure applied by a pressure applicator 217. The "area of the main surface" as used herein means an area of the main surface of the sintered ceramics when viewed from the vertical upper side.

### (Hot Press Process)

After the filling process is completed, the hot press process (hot press sintering) is performed using, for example, the hot press apparatus 200 illustrated in FIG. 7. That is, while applying a predetermined pressure to a mixture 210 filled in the jig 208 and compressing it, the mixture 210 in the jig 208 is heated at a predetermined temperature, to obtain sintered ceramics.

The hot press apparatus 200 illustrated in FIG. 7 includes a processing container 203 comprising SUS or the like and including the processing chamber 201 therein. The pressure applicator 217 (e.g., a hydraulic press type pressure applicator 217) is provided inside the processing chamber 201. The pressure applicator 217 is configured to be able to apply a predetermined pressure to the mixture 210 filled in the jig 208. Further, a heater 207 that heats the mixture 210 in the jig 208 to a predetermined temperature is provided inside the processing chamber 201. The heater 207 is arranged to surround the jig 208 concentrically. A temperature sensor 209 that measures the temperature inside the processing chamber 201 is provided inside the processing chamber 201. Each member included in the hot press apparatus 200 is connected to a controller 280 configured as a computer, and procedures and conditions described later are controlled by programs executed on the controller 280.

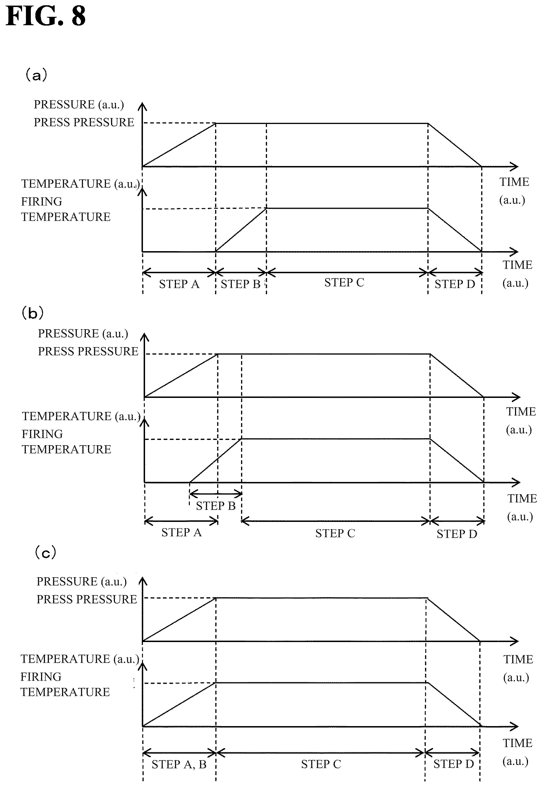

An example of the hot press process performed using the hot press apparatus 200 described above will be described using FIG. 8(a). In the hot press process, the following four steps, that is, steps A to D are performed.

### [Step A]

First, the jig 208 filled with the mixture 210 is put (loaded) into the processing chamber 201 and placed at a predetermined position of the pressure applicator 217. Then, the inside of the processing chamber 201 is transformed into an inert gas atmosphere or vacuum atmosphere, and the pressure applicator 217 starts pressurizing the mixture 210 in the jig 208. At this time, pressure is applied in a direction perpendicular to a pressing surface as indicated by a white arrow in FIG. 8(a).

In this step, the pressure is gradually increased at a rate of, for example, 1 kgf/cm² or less per minute until the pressure applied to the mixture 210 reaches a press pressure in step C described later. That is, a pressure increase rate is 1 kgf/cm²·min or less.

### [Step B]

After the pressure applied to the mixture 210 reaches the predetermined press pressure, heating of the mixture 210 is started while maintaining the application of the predetermined press pressure. In this step, the mixture 210 is heated until the mixture 210 reaches a sintering temperature (firing temperature) in step C described later.

### [Step C]

After the temperature of the mixture 210 reaches the sintering temperature, hot press sintering is performed by maintaining the surface to be the main surface of the sintered ceramics for a predetermined time in a state of being at a predetermined sintering temperature, while applying the predetermined press pressure to the mixture 210. Specifically, the surface to be the main surface of the sintered ceramics is maintained for 12 hours or more, preferably 24 hours or more in the state of being at a temperature of 900 to 1200 °C over its entire surface, while applying a pressure of 80 to 500 kgf/cm² to the mixture 210. This obtains predetermined KNN sintered ceramics. In this event, the temperature of the heater 207 is controlled based on a temperature detected by the temperature sensor 209 so as to make the temperature on the surface to be the main surface of the sintered ceramics uniform (in-plane uniform), that is, so as to minimize any unevenness of sintering temperature on the surface to be the main surface of the sintered ceramics as much as possible. In this step, a surface to be a top surface when the jig 208 is placed on the pressure applicator 217 is the surface to be the main surface of the sintered ceramics, and the temperature of the heater 207 is controlled such that the temperature on the surface to be the main surface of the sintered ceramics is 900 to 1200 °C over its entire surface.

Conditions for this step are exemplified as follows.
Sintering temperature: 900 to 1200 °C, preferably 1000 to 1150 °C
Press pressure: 80 to 500 kgf/cm², preferably 100 to 400 kgf/cm²
Sintering time: 12 hours or more, preferably 24 hours or more
Atmosphere: inert gas atmosphere or vacuum atmosphere

### [Step D]

After the surface to be the main surface of the sintered ceramics is maintained for 12 hours or more in the state of being at 900 to 1200 °C over the entire surface, depressurizing and cooling (temperature reduction) to the mixture 210 are started. After the temperature of the obtained sintered ceramics reduces to a predetermined temperature, the jig 208 (with the sintered ceramics) is unloaded from the processing chamber.

By performing the hot press process through steps A to D described above, the target material 100 with high Vickers hardness can be obtained over the entire sputter surface region.

Specifically, in step A, the pressure is gradually increased at a rate of, for example, 1 kgf/cm²·min or less, and in step C, the sintering time is made much longer than the conventional sintering time, that is, the surface to be the main surface of the sintered ceramics is maintained for 12 hours or more in the state of being at a temperature of 900 to 1200 °C over its entire surface, whereby the bonding between particles included in the sintered ceramics can be strengthened. As a result, this can obtain the large-sized target material 100 having the area of the sputter surface 101 of 44.2 cm² or more, the thickness of 3 mm or more, and the Vickers hardness of 150 or more over the entire sputter surface region even when there is "unevenness of filling of the raw material powder" or "unevenness of sintering temperature".

When the pressure increase rate in step A exceeds 1 kgf/cm²·min, regions with the Vickers hardness of less than 150 may sometimes appear on the sputter surface 101.

The lower the pressure increase rate, that is, the more slowly the pressure is increased in step A, the more surely the regions with the Vickers hardness of less than 150 can be avoided from appearing on the sputter surface 101. For this reason, the lower limit of the pressure increase rate is not particularly limited. However, when the pressure increase rate is less than 0.2 kgf/cm²·min, the productivity may sometimes decrease, or the manufacturing costs may sometimes increase. From the viewpoint of ensuring productivity and suppressing cost increase, the pressure increase rate can be set to, for example, 0.2 kgf/cm²·min or more.

When the sintering time in step C is less than 12 hours, even by setting the sintering temperature within the above range, regions with the Vickers hardness of less than 150 may sometimes appear on the sputter surface 101.

The longer the sintering time, the higher the Vickers hardness can be. Thus, the upper limit of the sintering time is not particularly limited. However, when the sintering time exceeds 100 hours or less, the productivity may sometimes decrease, and the manufacturing costs may sometimes increase. From the viewpoint of ensuring productivity and suppressing cost increase, the sintering time can be set to, for example, 100 hours or less, preferably 72 hours or less.

When the sintering temperature in step C is less than 900 °C, even by setting the sintering time to 12 hours or more, the sintering may become insufficient, and regions with the Vickers hardness of less than 150 may sometimes appear on the sputter surface 101. When the sintering temperature exceeds 1200 °C, cracks and chips may sometimes occur in sintered ceramics. In addition, dispersion of K and Na may cause deviations in the composition of the target material, and as a result, the composition of K, Na, and Nb may not satisfy the above relationship over the entire main surface region in the KNN film deposited using such a target material.

Since the press pressure is 80 kgf/cm² or more in step C, the target material 100 with the Vickers hardness of 150 or more can be surely obtained over the entire sputter surface region. When the press pressure is less than 80 kgf/cm²·min, the compression of the target material may become insufficient, and regions with the Vickers hardness of less than 150 may sometimes appear on the sputter surface 101. Since the press pressure is 500 kgf/cm² or less, the occurrence of cracks, damage to the jig 208, or the like during the production of the target material 100 can be avoided. When the press pressure exceeds 500 kgf/cm², the sintered ceramics may become cracked, or the jig 208 may be damaged, during the production of the target material 100.

By performing steps A to D described above, the relative density of the target material 100 can be 60 % or more, preferably 70 % or more, and more preferably 80 % or more, over the entire sputter surface region.

### (Heat Treatment)

After the hot press process is completed, a predetermined heat treatment is performed onto the obtained sintered ceramics using a heat treatment apparatus. The heat treatment is performed while controlling a temperature of a heater included in the heat treatment apparatus such that the temperature on the main surface of the sintered ceramics becomes uniform (in-plane uniform).

Conditions for the heat treatment are exemplified as follows.
Temperature: 600 to 1100 °C, preferably 700 to 1000 °C
Atmosphere: Air or atmosphere containing oxygen (O)
Time: 1 to 40 hours, preferably 5 to 30 hours

When sintering is performed in an inert gas atmosphere or vacuum atmosphere during the hot press process, the KNN sintered ceramics, which is an oxide, may be somewhat reduced in some cases, resulting in generations of oxygen defects in the sintered ceramics. By performing the heat treatment under the conditions described above, the oxygen defects generated in the sintered ceramics can be replenished with oxygen. As a result, the target material 100 with higher resistivity can be obtained. For example, the volume resistivity of the target material 100 can be 1000 kΩcm or more, preferably 1000 kΩcm or more over the entire sputter surface region.

### (Finishing Treatment)

After the heat treatment is completed, an outline or a thickness of the sintered ceramics obtained after the heat treatment is adjusted as needed, or the surface of the sintered ceramics is polished to adjust its surface condition. Thus, the target material 100 as illustrated in FIG. 5 is obtained.

### (6) Effects

According to the present disclosure, one or more of the following effects described are obtained.
(a) In this embodiment, even though the KNN film 3 has a large diameter (a diameter of 3 inches or more), the composition of K, Na, and Nb in the KNN film 3 satisfies the relationship of 0.94 ≤ (K + Na)/Nb ≤ 1.03 over the entire main surface region. This allows, for example, the dielectric breakdown voltage of the KNN film 3 to be made uniform over the entire main surface region. As a result, variations in dielectric breakdown voltage among the plurality of piezoelectric elements 20 or among piezoelectric device modules 30, obtained from one piezoelectric stack 10 can be avoided. This can improve the yield and the reliability of the piezoelectric element 20 and the piezoelectric device module 30.
(b) The composition of K, Na, and Nb in the KNN film 3 satisfies 0.94 ≤ (K + Na)/Nb ≤ 1.03, thereby allowing the dielectric breakdown voltage of the KNN film 3 to be, for example, 300 kV/cm or more, preferably 500 kV/cm or more.
(c) The composition of K, Na, and Nb in the KNN film 3 satisfies the above relationship over the entire main surface region, thereby allowing the dielectric breakdown voltage of the KNN film 3 to be, for example, 300 kV/cm or more, preferably 500 kV/cm or more, over the entire main surface region.
(d) The KNN film 3 is deposited by sputtering using the target material 100 having an area of the sputter surface 101 of 44.2 cm² or more, the thickness of 3 mm or more, and the Vickers hardness of 150 or more over the entire sputter surface region, which can thereby obtain the KNN film 3 with a large diameter in which the composition of K, Na, and Nb satisfies the above relationship over the entire main surface region.

Here, it can be considered that an evaluation method of the Vickers hardness of the sputter surface involves measuring and evaluating the Vickers hardness of the sputter surface at a total of nine points, consisting of one point at the center of the sputter surface, four points at intervals of 90 degrees at a radius of 1/2, and four points at intervals of 90 degrees inward of an outer edge by a predetermined distance. However, since this evaluation method has fewer evaluation points than that in this embodiment, the Vickers hardness may not be accurately evaluated over the entire sputter surface region. In particular, when the target material has the area of the sputter surface of 44.2 cm² or more and the thickness of 3 mm or more, regions where the Vickers hardness is less than 150 may be missed even though these regions have appeared.

In contrast, in the target material 100 of this embodiment, when the Vickers hardness is measured at measurement points set at 1 cm intervals in a grid pattern over a region of the sputter surface 101, excluding its periphery having a width of 5 mm from the edge of the sputter surface 101, the Vickers hardness is 150 or more at all the measurement points (e.g., 37 points in a case where the sputter surface 101 has the area of 44.2 cm² or more). Thus, the KNN film 3 with a large diameter, in which the composition of K, Na, and Nb satisfies the above relationship over the entire main surface region, can be obtained by depositing the KNN film 3 on the substrate 1 with a large diameter by sputtering using the target material 100 having the area of the sputter surface 101 of 44.2 cm² or more and the thickness of 3 mm or more and the high Vickers hardness over the entire sputter surface region.

(e) In step A described above, the pressure is gradually increased at a rate of, for example, 1 kgf/cm²·min or less, and in step C described above, the surface to be the main surface of the sintered ceramics is maintained for 12 hours or more in the state of being at a temperature of 900 to 1200 °C, whereby the bonding between particles included in the KNN sintered ceramics can be strengthened. Therefore, the target material 100 can be obtained that has the area of the sputter surface 101 of 44.2 cm² or more, the thickness of 3 mm or more, and the Vickers hardness of 150 or more over the entire sputter surface region, even though there is "unevenness of filling of the raw material powder" or "unevenness of sintering temperature".

(f) By using the target material 100 with the Vickers hardness of 150 or more over the entire sputter surface region, the occurrence of cracks in the sputter surface 101 can be suppressed even when the KNN film 3 is deposited by sputtering at a high deposition rate. This increases the life of the target material 100 and also reduces a frequency of maintenance of a sputtering apparatus (deposition apparatus). As a result of these, manufacturing costs of the piezoelectric stack 10 can be reduced.

### (7) Modified Examples

This embodiment can be modified as described in the following modified examples. In the following description of the modified examples, the same components as those of the above-described embodiments are denoted by the same reference characters, and their descriptions are omitted. In addition, the above-described embodiments and the following modified examples can be combined arbitrarily.

### (Modified Example 1)

The piezoelectric stack 10 may not include the bottom electrode film 2. That is, the piezoelectric stack 10 may be configured to include the substrate 1 with a large diameter, the KNN film 3 with a large diameter deposited on the substrate 1, and the top electrode film 4 (electrode film) deposited on the KNN film 3.

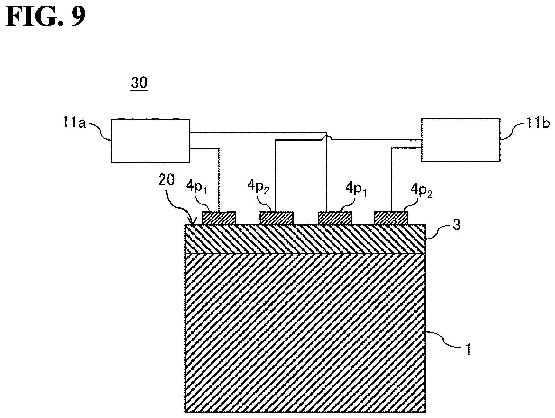

FIG. 9 is a view illustrating a schematic configuration of a piezoelectric device module 30 produced using the piezoelectric stack 10 according to this modified example. The piezoelectric device module 30 is configured to include: at least a piezoelectric element 20 obtained by shaping the piezoelectric stack 10 into a predetermined shape; and the voltage applicator 11a and the voltage detector 11b which are connected to the piezoelectric element 20. In this modified example, the piezoelectric element 20 has patterned electrodes formed by shaping an electrode film into a predetermined pattern. For example, the piezoelectric element 20 has a pair of positive and negative patterned electrodes 4pi on an input side and a pair of positive and negative patterned electrodes 4p₂ on an output side. A comb-shaped electrode (Inter Digital Transducer, abbreviated as IDT) is exemplified as the pattern electrodes 4p₁, 4p₂.

The voltage applicator 11a is connected between the patterned electrodes 4p₁, and the voltage detector 11b is connected between the patterned electrodes 4p₂, whereby the piezoelectric device module 30 can function as a filter device such as a surface acoustic wave (abbreviated as SAW) filter. By applying a voltage between the patterned electrodes 4pi using the voltage applicator 11a, SAW can be excited in the KNN film 3. The frequency of SAW to be excited can be adjusted, for example, by adjusting a pitch between the patterned electrodes 4pi. For example, the shorter the pitch of the IDT as the pattern electrodes 4pi, the higher the frequency of SAW becomes, and the longer the above pitch, the lower the frequency of SAW becomes. A voltage is generated between the patterned electrodes 4p₂, due to SAW having a predetermined frequency (frequency component) determined according to the pitch of the IDT as the patterned electrodes 4p₂ or the like, out of SAWs which are excited by the voltage applicator 11a, propagate through the KNN film 3, and reach the patterned electrode 4p₂. By detecting this voltage using the voltage detector 11b, SAW having the predetermined frequency can be extracted out of the excited SAWs. The "predetermined frequency" as used herein can include not only a predetermined frequency, but also a predetermined frequency band whose center frequency is the predetermined frequency.

In this modified example as well, the KNN film 3 with a large diameter, in which the composition of K, Na, and Nb satisfies the relationship of 0.94 ≤ (K + Na)/Nb ≤ 1.03 over the entire main surface region, can be obtained by depositing the KNN film 3 by sputtering using the large-sized target material 100 with the Vickers hardness of 150 or more over the entire sputter surface region.

### (Modified Example 2)

The piezoelectric stack 10 may not include the top electrode film 4. That is, the piezoelectric stack 10 may be configured to include the substrate 1 with a large diameter, the bottom electrode film 2 deposited on the substrate 1, and the KNN film 3 with a large diameter deposited on the bottom electrode film 2. In this modified example as well, the KNN film 3 with a large diameter, in which the composition of K, Na, and Nb satisfies the relationship of 0.94 ≤ (K + Na)/Nb ≤ 1.03 over the entire main surface region, can be obtained by depositing the KNN film 3 by sputtering using the large-sized target material 100 with the Vickers hardness of 150 or more over the entire sputter surface region.

### (Modified Example 3)

In the above-described embodiment, an example has been described in which the powder comprising the compound of K (e.g., K₂CO₃-powder), the powder comprising the compound of Na (e.g., Na₂CO₃-powder), and the powder comprising the compound of Nb (e.g., NbaOs-powder) are mixed at a predetermine ratio in the mixing process when producing the target material 100, but the mixing process is not limited thereto.

For example, in the mixing process, the mixture may be obtained by mixing powder comprising a compound containing K and Nb, and powder comprising a compound containing Na and Nb, at a predetermined ratio. The "powder comprising a compound containing K and Nb" as used herein means powder containing the compound of K and Nb as a main component, and it may include a case in which the powder consists of the compound containing K and Nb, as well as a case in which the powder contains powders of other compounds in addition to the powder, which is the main component, of the compound of K and Nb. Similarly, the "powder comprising a compound containing Na and Nb" as used herein means powder containing the compound of Na and Nb as a main component, and it may include a case in which the powder consists of a powder of a compound containing Na and Nb alone, as well as a case in which the powder contains powders of other compounds in addition to the powder, which is the main component, of the compound of Na and Nb.

The compound containing K and Nb is at least one selected from the group consisting of oxides (composite oxides) containing K and Nb, and compounds (e.g., carbonates, oxalates) containing K and Nb that are transformed into oxides when heated. For example, KNbO₃-powder can be used as the powder of the compound containing K and Nb. KNbO₃-powder can be obtained, for example, by mixing a compound of K (e.g., K₂CO₃-powder) and a compound of Nb (e.g., NbzOs-powder), pre-baking a mixture, and then pulverizing and mixing the mixture obtained after pre-baking, using a ball mill or the like.

The compound containing Na and Nb is at least one selected from the group consisting of oxides (composite oxides) containing Na and Nb, and compounds (e.g., carbonates, oxalates) containing Na and Nb that are transformed into oxides when heated. For example, NaNbO₃-powder can be used as the powder of the compound containing Na and Nb. NaNbO₃-powder can be obtained, for example, by mixing a compound of Na (e.g., Na₂CO₃-powder) and a compound of Nb (e.g., Nb₂O₅-powder), pre-baking a mixture, and then pulverizing and mixing the mixture obtained after pre-baking, using a ball mill or the like.

In this case, the composition of the target material 100 can be controlled by adjusting a mixing ratio of the KNbO₃-powder and the NaNbO₃-powder, a mixing ratio of the compound of K and the compound of Na used when producing the KNbO₃-powder, and a mixing ratio of the compound of Na and the compound of Nb used when producing the NaNbO₃-powder.

In this modified example, the conditions for pre-baking during the production of the KNbO₃-powder and the production of the NaNbO₃-powder can be set similar to those for the pre-firing process in the above-described embodiment, and the conditions for mixing can be set similar to those for the mixing process in the above-described embodiment.

In this modified example as well, the similar effects to those in the above-described embodiment can be obtained by performing the hot press process described above. Specifically, in step A, the pressure is gradually increased at a rate of, for example, 1 kgf/cm²·min or less, and in step C, the surface to be the main surface of the sintered ceramics is maintained for 12 hours or more in the state of being at a temperature of 900 to 1200 °C, which can thereby obtain the large-sized target material 100 having the area of the sputter surface 101 of 44.2 cm² or more, the thickness of 3 mm or more, and the Vickers hardness of 150 or more over the entire sputter surface region, even though there is "unevenness of filling of the raw material powder" or "unevenness of sintering temperature". In addition, the KNN film 3 with a large diameter, in which the composition of K, Na, and Nb satisfies the above relationship over the entire main surface region, can be obtained by depositing the KNN film 3 by sputtering using the target material 100 of this modified example.

### (Modified Example 4)

In the above-described embodiments, an example has been described in which after step A is completed, step B is started. That is, the description has been given on the example in which after the pressure in step A reaches the press pressure, heating of the mixture 210 is started. However, the present disclosure is not limited to the above-described embodiments. For example, as illustrated in FIG. 8(b), step A and step B described above may partially overlap each other for a period of time. That is, step B (temperature increase) may be started while step A is being performed (during pressure increase). Also, for example, as illustrated in FIG. 8(c), the period of step A and the period of step B may be the same. Even in these cases, in step A, the pressure is gradually increased at a rate of, for example, 1 kgf/cm²·min or less, and in step C, the surface to be the main surface of the sintered ceramics is maintained for 12 hours or more in the state of being at a temperature of 900 to 1200 °C, whereby the similar effects to those in the above-described embodiments and modified examples can be obtained.

### (Modified Example 5)

In the above-described embodiments and modified examples, an example has been described in which a mixing method for each powder in the mixing and pulverizing processes is wet mixing, but the mixing method is not limited to this. The mixing method in the mixing process may be dry mixing. That is, in the mixing process, respective powders may be mixed using a mixer such as an attritor.

### (Modified Example 6)

In the above-described embodiments, an example has been described in which the pre-firing and pulverizing processes and the heat treatment are performed, but the processes are not limited thereto. These processes can be performed as needed. That is, these processes may not be performed as long as the large-sized target material 100 having an area of the sputter surface 101 of 44.2 cm² or more, a thickness of 3 mm or more, and the Vickers hardness of 150 or more over the entire sputter surface region can be obtained.

### (Modified Example 7)

For example, heating in each of the pre-firing process and the heat treatment may be performed in multiple times. In this modified example as well, the large-sized target material 100 having the area of the sputter surface 101 of 44.2 cm² or more, the thickness of 3 mm or more, and the Vickers hardness of 150 or more over the entire sputter surface region can be obtained.

### (Modified Example 8)

For example, an orientation control layer, which controls the orientation of crystals constituting the KNN film 3, may be provided between the bottom electrode film 2 and the KNN film 3, that is, directly under the KNN film 3. In a case where the bottom electrode film 2 is not provided, the orientation control layer may be provided between the substrate 1 and the KNN film 3. The orientation control layer may be provided using a material which is a metal oxide such as SRO, LNO, or strontium titanium oxide (SrTiO₃, abbreviated as STO), and which is different from the material comprising the bottom electrode film 2, for example. Preferably, the crystals constituting the orientation control layer are preferentially oriented in (100) with respect to the main surface of the substrate 1. This can ensure that the orientation ratio of the KNN film 3 is, for example, 80 % or more, preferably 90 % or more.

### Examples

The following is a description of the experimental results that support the effectiveness of the above-described embodiments.

After obtaining sintered ceramics by performing the mixing process, the pre-firing process, the pulverizing process, the filling process, and the hot press processes and the heat treatment, the sintered ceramics were subjected to the finishing treatment, thereby producing target materials (samples 1 to 15), each having an area of a circular sputter surface of 44.2 cm² and a thickness of 5 mm.

In sample 1, the mixing ratio of a K₂CO₃-powder, a Na₂CO₃-powder, and a NbzOs-powder was adjusted in the mixing process such that a value of (K + Na)/Nb was 0.95. In step A of the hot press process of the above-described embodiment, the pressure was gradually increased at a pressure increase rate of 1 kgf/cm²·min until the press pressure reached 80 kgf/cm². In step C of the hot press process of the above-described embodiment, the surface to be the main surface of the sintered ceramics was maintained for 12 hours in the state of being at a temperature of 900 °C over its entire surface. That is, in Step C, the sintering temperature was set at 900 °C, and the sintering time was set to 12 hours. Other conditions were set to the predetermined conditions that fell within the ranges described in the above-described embodiments.

In sample 2, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 1000 °C, and the sintering time was set to 12 hours. The producing procedure and other conditions for the production were similar to those for sample 1.

In sample 3, the mixing ratio of the K₂CO₃-powder, the Na₂CO₃-powder, and the Nb₂O₅-powder was adjusted in the mixing process such that the value of (K + Na)/Nb was 1.20. In step C, the sintering temperature was set at 1200 °C, and the sintering time was set to 12 hours. The producing procedure and other conditions for the production were similar to those for sample 1.

In sample 4, the mixing ratio of the K₂CO₃-powder, the Na₂CO₃-powder, and the Nb₂O₅-powder was adjusted in the mixing process such that the value of (K + Na)/Nb was 1.07. The pressure increase rate in step A was set to 0.5 kgf/cm²·min. In step C, the sintering temperature was set at 950 °C, and the sintering time was set to 12 hours. The producing procedure and other conditions for the production were similar to those for sample 1.

In sample 5, the mixing ratio of the KaCO₃-powder, the Na₂CO₃-powder, and the Nb₂O₅-powder was adjusted in the mixing process such that the value of (K + Na)/Nb was 1.07. The pressure increase rate in step A was set to 0.2 kgf/cm²·min. In step C, the sintering temperature was set at 950 °C, and the sintering time was set to 12 hours. The producing procedure and other conditions for the production were similar to those for sample 1.

In sample 6, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 950 °C, and the sintering time was set to 24 hours. The producing procedure and other conditions for the production were similar to those for sample 1.

In sample 7, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 950 °C, and the sintering time was set to 48 hours. The producing procedure and other conditions for the production were similar to those for sample 1.

In sample 8, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 850 °C, and the sintering time was set to 12 hours. The producing procedure and other conditions for the production were similar to those for sample 1.

In sample 9, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 800 °C, and the sintering time was set to 12 hours. The producing procedure and other conditions for the production were similar to those for sample 1.

In sample 10, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 1250 °C, and the sintering time was set to 12 hours. The producing procedure and other conditions for the production were similar to those for sample 1.

In sample 11, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 1300 °C, and the sintering time was set to 12 hours. The producing procedure and other conditions for the production were similar to those for sample 1.

In sample 12, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 950 °C, and the sintering time was set to 6 hours. The producing procedure and other conditions for the production were similar to those for sample 1.

In sample 13, the mixing ratio of the K₂CO₃-powder, the Na₂CO₃-powder, and the Nb₂O₅-powder was adjusted in the mixing process such that the value of (K + Na)/Nb was 1.07. In step C, the sintering temperature was set at 950 °C, and the sintering time was set to 3 hours. The producing procedure and other conditions for the production were similar to those for sample 1.

In sample 14, the mixing ratio of the K₂CO₃-powder, the Na₂CO₃-powder, and the Nb₂O₅-powder was adjusted in the mixing process such that the value of (K + Na)/Nb was 1.07. The pressure increase rate in step A was set to 2 kgf/cm²·min. In step C, the sintering temperature was set at 950 °C, and the sintering time was set to 12 hours. The producing procedure and other conditions for the production were similar to those for sample 1.

In sample 15, the mixing ratio of the K₂CO₃-powder, the Na₂CO₃-powder, and the Nb₂O₅-powder was adjusted in the mixing process such that the value of (K + Na)/Nb was 1.07. The pressure increase rate in step A was set to 4 kgf/cm²·min. In step C, the sintering temperature was set at 950 °C, and the sintering time was set to 12 hours. The producing procedure and other conditions for the production were similar to those for sample 1.

### <Evaluation>

The target materials of sample 1 to 15 were evaluated for cracks and Vickers hardness. In addition, KNN films deposited by sputtering using the respective samples were evaluated, and the occurrence of cracks in each sample after the sputter deposition was also evaluated.

### (Crack Evaluation)

Each sample was visually evaluated for occurrence of cracks and chips. As a result, the occurrence of a chip was confirmed in samples 10 and 11. No cracks or chips were observed in samples other than samples 10 and 11. From this, it was found that cracks or chips occurred in sintered ceramics when the temperature (sintering temperature) in step C exceeded 1200 °C.

### (Evaluation of Vickers Hardness)

The Vickers hardness of the sputter surface was measured for each sample other than samples 10 and 11 where chip(s) occurred. The Vickers hardness was measured on the sputter surface at 1 cm intervals in a grid pattern over its entire region excluding a region having a width of 5 mm from the edge of the sputter surface. That is, the Vickers hardness was measured at 37 points for each of samples 1 to 9 and 12 to 15 having the area of the circular sputter surface of 44.2 cm² and the thickness of 3 mm. The Vickers hardness was measured in accordance with JISR1610 by making an indentation on a test surface (sputter surface) under test conditions described in the above-described embodiments, using a micro-Vickers hardness tester HM-114, manufactured by Mitutoyo Corporation. The measurement results are shown in the following Table 1. In Table 1, the term "passing measurement points" refers to the number of measurement points where the Vickers hardness was 150 or more, whereas the term "failing measurement points" refers to the number of measurement points where the Vickers hardness was less than 150.

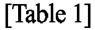

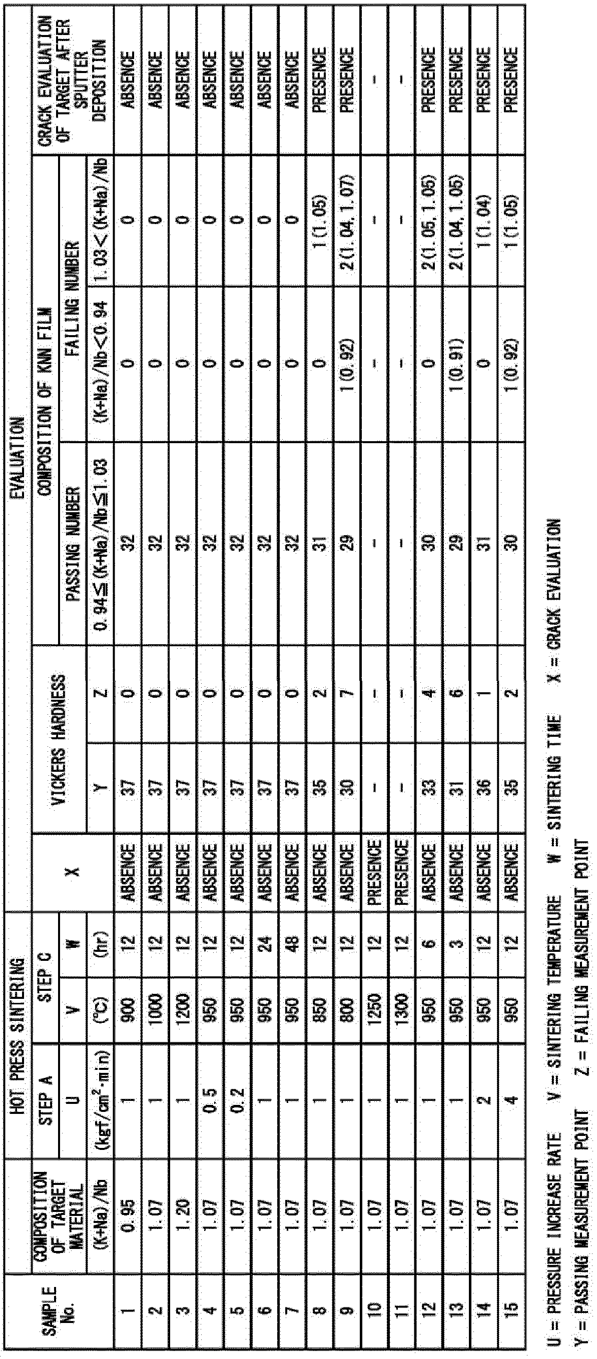

As shown in Table 1, it could be confirmed that in samples 1 to 7 where the pressure increase rate was set to 1 kgf/cm²·min or less in step A, and the surface to be the main surface of the sintered ceramics was maintained for 12 hours or more in the state of being at a temperature of 900 to 1200 °C in step C, the Vickers hardness could be 150 or more over the entire sputter surface region, even though the area of the sputter surface was 44.2 cm² or more and the thickness of the target material was 3 mm or more.

In contrast, it could be confirmed that a region (spot) with the Vickers hardness of less than 150 appeared on the sputter surface in samples 8 and 9 where the sintering temperature was less than 900 °C in step C, in samples 12 and 13 where the sintering time was less than 12 hours, and in samples 14 and 15 where the pressure increase rate in step A exceeded 1 kgf/cm²·min.

### (Evaluation of KNN Film)

A KNN film was deposited by sputtering using each sample other than samples 10 and 11 where cracks occurred, according to the following procedure.

As a substrate, a Si-substrate with a diameter of 4 inches and a thickness of 510 µm, having a surface oriented in (100) direction, with a thermal oxide film (SiO₂-film) of 200 nm in thickness provided on its surface, was prepared. On this substrate (on the thermal oxide film), a Ti-layer (thickness: 2 nm) as an adhesion layer and a Pt-film (oriented in (111) direction with respect to a main surface of the substrate, thickness: 200 nm) as a bottom electrode film were deposited by the RF magnetron sputtering method. Then, using each of samples 1 to 9 and 12 to 15 as a target material, a KNN film with a diameter of 3 inches (preferentially oriented in (001) direction with respect to the surface of the substrate, thickness: 2 µm) was deposited on the bottom electrode film by the RF magnetron sputtering.

The conditions for depositing the Ti-layer were as follows.
Temperature (substrate temperature): 300 °C
RF-power density: 14.8 W/cm² (1200W/4-inch diameter circle)
Atmosphere: Ar-gas atmosphere
Atmospheric pressure: 0.3 Pa
Deposition rate: rate at which a Ti -layer with a thickness of 2.5 nm is deposited in 30 seconds

The conditions for depositing the Pt-layer were as follows.
Temperature (substrate temperature): 300 °C
RF-power density: 14.8 W/cm² (1200W/4-inch diameter circle)
Atmosphere: Ar-gas atmosphere
Atmospheric pressure: 0.3 Pa
Time: 5 minutes

The conditions for depositing the KNN film were as follows.
RF-power density: 3.0 W/cm² (2200W/12-inch diameter circle)
Atmosphere: Atmosphere of a mixed gas of Ar-gas + O₂-gas
Atmospheric pressure: 0.3 Pa
Ar/O₂ partial voltage ratio: 25/1
Temperature (substrate temperature): 600 °C
Deposition rate: 1 µm/hr

The composition of K, Na, and Nb was then analyzed for each of the obtained KNN films. Specifically, first, the KNN film of a region excluding an outer peripheral region having a width of 5 mm from the edge of the main surface of the KNN film, was cut at 1 cm intervals in a grid pattern, to obtain a plurality of small pieces. Of the plurality of small pieces obtained, small pieces with a planar area of 25 mm² or more (in this example, 32 small pieces per KNN film) were decomposed by heating with sulfuric acid, nitric acid, hydrofluoric acid, and hydrochloric acid, and then dissolved by heating with dilute hydrogen peroxide water and dilute hydrofluoric acid to make up a constant volume. The resulting solution is subjected to AAS using Z-2300, manufactured by Hitachi High-Technologies Corporation, to measure contents of K and Na in the KNN film. In addition, the resulting solution is subjected to ICP-AES using PS3520VDDII, manufactured by Hitachi High-Tech Science Corporation, to measure content of Nb in the KNN film. The obtained contents of K, Na, and Nb were converted into an atomic ratio, and from this atomic ratio, the composition of K, Na, and Nb in the KNN film, that is, a value of (K + Na)/Nb, was calculated.

The analysis results of the composition of K, Na, and Nb in the KNN film are shown in Table 1. In Table 1, the term "passing number" refers to the number of small pieces in which the composition of K, Na, and Nb in the KNN film satisfied the relationship of 0.94 ≤ (K + Na)/Nb ≤ 1.03. The term "failing number" refers to the number of small pieces in which the composition of K, Na, and Nb in the KNN film did not satisfy the relationship of 0.94 ≤ (K + Na)/Nb ≤ 1.03, that is, the sum of the number of small pieces in which the value of (K + Na)/Nb was less than 0.94 ((K + Na)/Nb < 0.94), and the number of small pieces in which the value of (K + Na)/Nb exceeded 1.03 (1.03 < (K + Na)/Nb). The numerical value shown inside a parenthesis in the "failing number" column is a value of (K + Na)/Nb in the small pieces that were determined to fail.

As shown in Table 1 above, it could be confirmed that in any of the KNN films with a large diameter of 3 inches, deposited using samples 1 to 7 with the Vickers hardness of 150 or more over the entire sputter surface region, the composition of K, Na, and Nb in the KNN film satisfied the relationship of 0.94 ≤ (K + Na)/Nb ≤ 1.03 over the entire main surface region.

On the other hand, it could be confirmed that in the KNN films deposited using samples 8, 9, and 12 to 15, where a region with the Vickers hardness of less than 150 appeared on the sputter surface, a spot in which the composition of K, Na, and Nb did not satisfy the relationship of 0.94 ≤ (K + Na)/Nb ≤ 1.03 appeared on the main surface of the KNN film. That is, it could be confirmed that in the KNN films deposited using samples 8, 9, and 12 to 15, a spot where the value of (K + Na)/Nb was less than 0.94 or a spot where the value of (K + Na)/Nb exceeded 1.03 appeared on the main surface of the KNN film.

### (Evaluation of Occurrence of Cracks in Each Sample After Sputter Deposition)

Samples 1 to 9 and 12 to 15 after the sputter deposition of the KNN film were visually evaluated for presence or absence of cracks on a sputter surface.

As a result, it could be confirmed that in samples 1 to 7 where the Vickers hardness was 150 or more over the entire sputter surface region, the sputter surface had no cracks even after the sputter deposition. That is, it could be confirmed that in samples 1 to 7, there were no spots with weak bonding between particles over the entire sputter surface region, and the occurrence of cracks and the occurrence of abnormal electrical discharge could be avoided during pre-sputtering or sputter deposition.

In contrast, it could be confirmed that in samples 8, 9, and 12 to 15 where a region with the Vickers hardness of less than 150 appeared on the sputter surface, the sputter surface after the sputter deposition had cracks.

### <Preferred Aspects of Present Disclosure>

Preferred aspects of the present disclosure will be supplementarily described hereinafter.

### (Supplementary description 1)

According to an aspect of the present disclosure, there is provided a piezoelectric stack, including:
a substrate having a main surface with a diameter of 3 inches or more; and
a piezoelectric film on the substrate, comprising an alkali niobium oxide containing K, Na, Nb, and O,
wherein in the piezoelectric film, a composition of K, Na, and Nb satisfies a relationship of 0.94 ≤ (K + Na)/Nb ≤ 1.03, preferably 0.96 ≤ (K + Na)/Nb ≤ 1.00, over an entire inner region of the main surface of the piezoelectric film, excluding its periphery.

### (Supplementary description 2)

Preferably, there is provided the piezoelectric stack according to the supplementary description 1, wherein a thickness of the piezoelectric film is 0.5 µm or more over the entire inner region of the main surface of the piezoelectric film, excluding the periphery.

### (Supplementary description 3)

Preferably, there is provided the piezoelectric stack according to the supplementary description 1 or 2, wherein the alkali niobium oxide further contains, as a dopant, at least one element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga.

### (Supplementary description 4)

Preferably, there is provided the piezoelectric stack according to any one of the supplementary descriptions 1 to 3, wherein a dielectric breakdown voltage of the piezoelectric film is 300 kV/cm or more, preferably 500 kV/cm or more, over the entire inner region of the main surface of the piezoelectric film, excluding the periphery. That is, when a predetermined electric field is applied to the piezoelectric film in its thickness direction, an electric field value at which a current density of the piezoelectric film becomes 100 µA/cm² or more is 300 kV/cm or more, preferably 500 kV/cm or more, over the entire inner region of the main surface of the piezoelectric film, excluding the periphery.

### (Supplementary description 5)

Preferably, there is provided the piezoelectric stack according to any one of the supplementary descriptions 1 to 4, further including:
a bottom electrode film between the substrate and the piezoelectric film.

### (Supplementary description 6)

Preferably, there is provided the piezoelectric stack according to any one of the supplementary descriptions 1 to 5, further including:
a top electrode film on the piezoelectric film.

### (Supplementary description 7)

According to another aspect of the present disclosure, there is provided a method of manufacturing a piezoelectric stack, including:
preparing a sputtering target material comprising sintered ceramics including an oxide containing K, Na, Nb, and O;
preparing a substrate having a main surface with a diameter of 3 inches or more; and
depositing a piezoelectric film on the substrate using the sputtering target material, the piezoelectric film comprising an alkali niobium oxide containing K, Na, Nb, and O and having a composition of K, Na, and Nb satisfying a relationship of 0.94 ≤ (K + Na)/Nb ≤ 1.03 over an entire inner region of a main surface of the piezoelectric film, excluding its periphery.

### (Supplementary description 8)

According to still another aspect of the present disclosure, there is provided a method of manufacturing a piezoelectric stack, including:
preparing a substrate having a main surface with a diameter of 3 inches or more; and
preparing a sputtering target material comprising sintered ceramics including an oxide containing K, Na, Nb, and O, the sputtering target material having a minimum value of Vickers hardness of 150 or more in a surface to be exposed to plasma (sputter surface) when depositing a piezoelectric film by a sputtering method; and
depositing the piezoelectric film comprising an alkali niobium oxide containing K, Na, Nb, and O under conditions of an RF-power density applied to the sputtering target material of 2.7 to 4.1 W/cm²; temperature of 500 to 700 °C; atmosphere containing at least oxygen gas; pressure of 0.1 Pa or higher and 0.8 Pa or lower; and deposition rate of 0.5 µm/hr or more.

### (Supplementary description 9)

According to still another aspect of the present disclosure, there is provided a method of manufacturing a piezoelectric stack, including:
depositing a piezoelectric film on a substrate using a sputtering target material comprising sintered ceramics including an oxide containing K, Na, Nb, and O, the piezoelectric film comprising an alkali niobium oxide containing K, Na, Nb, and O,
wherein in the deposition of the piezoelectric film, a sputtering target material satisfying a relationship of R1 > R2 is used as the sputtering target material,
where R1 is an average value of (K + Na)/Nb, representing a composition of K, Na, and Nb, in a surface to be exposed to plasma when depositing the piezoelectric film, and
R2 is an average value of (K + Na)/Nb, representing a composition of K, Na, and Nb, in a main surface of the piezoelectric film deposited on the substrate.

### (Supplementary description 10)

According to still another aspect of the present disclosure, there is provided a sputtering target material, comprising sintered ceramics including an oxide containing K, Na, Nb, and O,
which is a sputtering target material to obtain a piezoelectric film when used as a sputtering target material to deposit a piezoelectric film by a sputtering method on a substrate having a main surface with a diameter of 3 inches or more, under conditions of temperature of 500 to 700 °C; RF-power density of 2.7 to 4.1 W/cm²; atmosphere containing at least oxygen gas; atmospheric pressure of 0.2 to 0.5 Pa; argon gas partial pressure/oxygen gas partial pressure of 30/1 to 20/1; and deposition rate of 0.5 to 2 µm/hr,
wherein the piezoelectric film obtained on the substrate comprises an alkali niobium oxide containing K, Na, Nb, and O, and has a composition of K, Na, and Nb satisfying a relationship of 0.94 ≤ (K + Na)/Nb ≤ 1.03 over an entire inner region of a main surface of the piezoelectric film, excluding its periphery.

### (Supplementary description 11)

According to still another aspect of the present disclosure, there is provided a sputtering target material, comprising sintered ceramics including an oxide containing K, Na, Nb, and O,
wherein an area of a surface to be exposed to plasma when depositing a piezoelectric film by a sputtering method is 44.2 cm² or more, and a thickness is 3 mm or more, and
a Vickers hardness of the surface to be exposed to the plasma is 150 or more, preferably 200 or more, over an entire inner region of the surface to be exposed to the plasma, excluding its periphery.

### (Supplementary description 12)

According to still another aspect of the present disclosure, there is provided a sputtering target material, comprising sintered ceramics including an oxide containing K, Na, Nb, and O,
which is a sputtering target material to obtain a piezoelectric film when used as a sputtering target material to deposit a piezoelectric film by a sputtering method on a substrate having a main surface with a diameter of 3 inches or more, under conditions of temperature of 500 to 700 °C; RF-power density of 2.7 to 4.1 W/cm²; atmosphere containing at least oxygen gas; atmospheric pressure of 0.2 to 0.5 Pa; argon gas partial pressure/oxygen gas partial pressure of 30/1 to 20/1; and deposition rate of 0.5 to 2 µm/hr,
wherein in any of a plurality of the piezoelectric films deposited using one sputtering target material, a composition of K, Na, and Nb in the piezoelectric film satisfies a relationship of 0.94 ≤ (K + Na)/Nb ≤ 1.03 over an entire inner region of a main surface of the piezoelectric film, excluding its periphery.

### (Supplementary description 13)

Preferably, there is provided the sputtering target material according to any one of the supplementary descriptions 10 to 12, further including: as a dopant, at least one element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga.

### (Supplementary description 14)

Preferably, there is provided the sputtering target material according to any one of the supplementary descriptions 10 to 13, wherein a relative density is 60 % or more over an entire region of a surface to be exposed to the plasma when depositing the piezoelectric film. The "relative density (%)" as used herein refers to a value calculated by (measured density/theoretical density of KNN (4.51 g/cm³)) × 100.

### (Supplementary description 15)

Preferably, there is provided the sputtering target material according to any one of the supplementary descriptions 10 to 14, wherein a volume resistivity is 1000 kΩcm or more over an entire region of a surface to be exposed to the plasma when depositing the piezoelectric film.

### (Supplementary description 16)

According to still another aspect of the present disclosure, there is provided a method of manufacturing a sputtering target material, the sputtering target material comprising sintered ceramics including an oxide containing K, Na, Nb, and O, and having an area of a surface of the sputtering target material to be exposed to plasma of 44.2 cm² or more, and having a thickness of 3 mm or more, the method including:
(a) mixing powder comprising a compound of K, powder comprising a compound of Na, and powder comprising a compound of Nb at a predetermined ratio, or mixing powder comprising a compound containing K and Nb and powder comprising a compound containing Na and Nb at a predetermined ratio, to obtain a mixture; and
(b) heating the mixture while applying a predetermined pressure to the mixture, to obtain sintered ceramics having an area of a main surface of 44.2 cm² or more and a thickness of 3 mm or more,
wherein in (b), a pressure is gradually increased at a rate of 1 kgf/cm² or less per minute until the predetermined pressure is reached, and a surface to be the main surface of the sintered ceramics is maintained for 12 hours or more in a state of being at a temperature of 900 to 1200 °C.

### (Supplementary description 17)

Preferably, there is provided the method according to the supplementary description 16, further including after (a) and before (b):
(c) pre-firing the mixture by heating at a predetermined temperature; and
(d) pulverizing the mixture after the pre-firing,
wherein in (b), the pulverized mixture obtained in (d) is heated while applying a predetermined pressure, to obtain the sintered ceramics.

### (Supplementary description 18)

Preferably, there is provided the method according to the supplementary description 16 or 17, further including after (b):
(e) heating the sintered ceramics at a predetermined temperature.

### DESCRIPTION OF SIGNS AND NUMERALS

- 1: Substrate
- 3: Piezoelectric film (KNN film)
- 10: Piezoelectric stack
- 100: Target material
- 101: Sputter surface

## Claims

1. A piezoelectric stack, comprising:
a substrate having a main surface with a diameter of 3 inches or more; and
a piezoelectric film on the substrate, comprising an alkali niobium oxide containing K, Na, Nb, and O,
wherein in the piezoelectric film, a composition of K, Na, and Nb satisfies a relationship of 0.94 ≤ (K + Na)/Nb ≤ 1.03 over an entire inner region of the main surface of the piezoelectric film, excluding a periphery of the main surface.

2. The piezoelectric stack according to claim 1, wherein the alkali niobium oxide further contains, as a dopant, at least one element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga.

3. A method of manufacturing a piezoelectric stack, comprising:
preparing a sputtering target material comprising sintered ceramics including an oxide containing K, Na, Nb, and O;
preparing a substrate having a main surface with a diameter of 3 inches or more; and
depositing a piezoelectric film on the substrate using the sputtering target material, the piezoelectric film comprising an alkali niobium oxide containing K, Na, Nb, and O and having a composition of K, Na, and Nb satisfying a relationship of 0.94 ≤ (K + Na)/Nb ≤ 1.03 over an entire inner region of a main surface of the piezoelectric film, excluding a periphery of the main surface.

4. A sputtering target material, comprising sintered ceramics including an oxide containing K, Na, Nb, and O,
which is a sputtering target material to obtain a piezoelectric film when used as a sputtering target material to deposit the piezoelectric film by a sputtering method on a substrate having a main surface with a diameter of 3 inches or more, under conditions of temperature of 500 to 700 °C; RF-power density of 2.7 to 4.1 W/cm²; atmosphere of a mixed gas of argon gas and oxygen gas; atmospheric pressure of 0.2 to 0.5 Pa; argon gas partial pressure/oxygen gas partial pressure of 30/1 to 20/1; and deposition rate of 0.5 to 2 µm/hr,
wherein the piezoelectric film obtained on the substrate comprises an alkali niobium oxide containing K, Na, Nb, and O, and has a composition of K, Na, and Nb satisfying a relationship of 0.94 ≤ (K + Na)/Nb ≤ 1.03 over an entire inner region of a main surface of the piezoelectric film, excluding a periphery of the main surface.

5. A sputtering target material, comprising sintered ceramics including an oxide containing K, Na, Nb, and O,
wherein an area of a surface to be exposed to plasma when depositing a piezoelectric film by a sputtering method is 44.2 cm² or more, and a thickness is 3 mm or more, and
a Vickers hardness of the surface to be exposed to the plasma is 150 or more over an entire inner region of the surface to be exposed to the plasma, excluding a periphery of the surface.

6. The sputtering target material according to claim 4 or 5, further including: as a dopant, at least one element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga.

7. A method of manufacturing a sputtering target material, the sputtering target material comprising sintered ceramics including an oxide containing K, Na, Nb, and O, and having an area of a surface of the sputtering target material to be exposed to plasma of 44.2 cm² or more, and having a thickness of 3 mm or more, the method comprising:
(a) mixing powder comprising a compound of K, powder comprising a compound of Na, and powder comprising a compound of Nb at a predetermined ratio, or mixing powder comprising a compound containing K and Nb and powder comprising a compound containing Na and Nb at a predetermined ratio, to obtain a mixture; and
(b) heating the mixture while applying a predetermined pressure to the mixture, to obtain sintered ceramics having an area of a main surface of 44.2 cm² or more and a thickness of 3 mm or more,
wherein in (b), a pressure is gradually increased at a rate of 1 kgf/cm² or less per minute until the predetermined pressure is reached, and a surface to be the main surface of the sintered ceramics is maintained for 12 hours or more in a state of being at a temperature of 900 to 1200 °C.
